(19) Europäisches Patentamt European Patent Office Office européen des brevets

(11) **EP 4 300 063 A1**

(12) **EUROPEAN PATENT APPLICATION**
published in accordance with Art. 153(4) EPC

(43) Date of publication:
**03.01.2024 Bulletin 2024/01**

(21) Application number: **22781132.0**

(22) Date of filing: **30.03.2022**

(51) International Patent Classification (IPC):
**G01L 1/16** (2006.01)      **H01L 41/087** (2006.01)
**H01L 41/09** (2006.01)      **H01L 41/113** (2006.01)
**H01L 41/193** (2006.01)

(52) Cooperative Patent Classification (CPC):
**G01L 1/16; H10N 30/20; H10N 30/30; H10N 30/60; H10N 30/857**

(86) International application number:
**PCT/JP2022/016136**

(87) International publication number:
**WO 2022/210922 (06.10.2022 Gazette 2022/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **31.03.2021 JP 2021061998**
              **31.03.2021 JP 2021061999**

(71) Applicant: **MITSUI CHEMICALS, INC.**
**Tokyo 104-0028 (JP)**

(72) Inventors:
- **MARUKO, Nobuhiro**
  **Nagoya-shi, Aichi 457-8522 (JP)**
- **HORI, Shigetaka**
  **Nagoya-shi, Aichi 457-8522 (JP)**
- **OZAKI, Katsutoshi**
  **Nagoya-shi, Aichi 457-8522 (JP)**
- **Mizuno, Shunya**
  **Sodegaura-shi, Chiba 299-0265 (JP)**

(74) Representative: **Hoffmann Eitle**
**Patent- und Rechtsanwälte PartmbB**
**Arabellastraße 30**
**81925 München (DE)**

(54) **PIEZOELECTRIC BASE MATERIAL, SENSOR, ACTUATOR, AND BIOMETRIC INFORMATION ACQUISITION DEVICE**

(57) A piezoelectric base material includes an elongated inner conductor, and a piezoelectric layer covering a periphery of the inner conductor. The piezoelectric layer includes a piezoelectric yarn wound around the inner conductor, and an adhering section that maintains a state in which the piezoelectric yarn is wound around the periphery of the inner conductor. The piezoelectric yarn includes an optically active polypeptide fiber that is a fiber including an optically active polypeptide. The piezoelectric layer has an elastic modulus Y of from 1.0 GPa to 8.0 GPa as measured by a microhardness measurement in accordance with JIS Z 2255.

FIG.1A

EP 4 300 063 A1

**Description**

BACKGROUND

Technical Field

The present invention relates to a piezoelectric base material, a sensor, an actuator, and a biological information acquisition device.

Related Art

In recent years, application of a piezoelectric body including a polypeptide having optical activity (hereinafter referred to as "optically active polypeptide") to piezoelectric devices such as sensors and actuators has been studied.
Patent Document 1 discloses a piezoelectric base material using a yarn-shaped piezoelectric body. The piezoelectric base material specifically disclosed in Patent Document 1 includes a tinsel wire, a particular raw silk, and a copper foil ribbon. The tinsel wire functions as a core. Raw silk is one example of a fiber including an optically active polypeptide. The raw silk is helically wound around the tinsel wire without forming a gap, such that the tinsel wire is not exposed. The raw silk wound around the tinsel wire is hereinafter referred to as "raw-silk layer". The copper foil ribbon is helically wound around the raw silk wound around the tinsel wire, without forming a gap, such that the raw silk is not exposed. The copper foil ribbon wound around the raw silk wound around the tinsel wire is hereinafter referred to as "copper foil ribbon layer". The tinsel wire, the raw-silk layer, and the copper foil ribbon layer are bound to each other by a cyanoacrylate adhesive. In other words, the tinsel wire, the raw-silk layer, and the copper foil ribbon layer are mechanically integrated together.

Prior Art Document

[Patent Document]

Patent Document 1: WO 2018/092886

SUMMARY

However, a piezoelectric base material having higher piezoelectric sensitivity than the piezoelectric base material described in Patent Document 1 has been demanded.
On the other hand, in cases where a line sensor having a coaxial line structure is produced using the piezoelectric base material disclosed in Patent Document 1 (for example, in cases of use as part of a wearable product or as an entire wearable product), the piezoelectric base material needs to be cut into a desired length in accordance with the mode of use, and a terminal needs to be attached to the piezoelectric base material. As a process before the attachment of the terminal, terminal-attachment preparation needs to be carried out. In the terminal-attachment preparation, the raw-silk layer and the copper foil ribbon layer are peeled off from both end portions of the piezoelectric base material, to expose the tinsel wire. More specifically, in the terminal-attachment preparation, the copper foil ribbon layer is peeled off from the raw-silk layer, and the raw-silk layer is removed for a length (normally about several millimeters) suitable for taking out the tinsel wire. The tinsel wire is then taken out.
However, in the piezoelectric base material disclosed in Patent Document 1, the tinsel wire, the raw-silk layer, and the copper foil ribbon layer are mechanically integrated together. Therefore, in the terminal-attachment preparation, there is a risk of breakage of the copper foil ribbon layer or the tinsel wire during the removal of the raw-silk layer. Moreover, the working time for the terminal-attachment preparation may be long. Thus, a piezoelectric base material that enables efficient terminal-attachment preparation has been demanded. Further, a piezoelectric base material having higher piezoelectric sensitivity than before has been demanded.
On embodiment of the present disclosure was carried out in view of the above circumstances.
An object in one embodiment of the disclosure is to provide a piezoelectric base material, a sensor, an actuator, and a biological information acquisition device, having excellent piezoelectric sensitivity.
An object in another embodiment of the invention is to enable efficient terminal-attachment preparation, and in addition, to provide a piezoelectric base material, a sensor, an actuator, and a biological information acquisition device, having excellent piezoelectric sensitivity.
Means for solving the above problem includes the following modes.

    <1> A piezoelectric base material including:

an elongated inner conductor; and
a piezoelectric layer covering a periphery of the inner conductor, the piezoelectric layer including:

a piezoelectric yarn wound around the inner conductor; and
an adhering section that maintains a state in which the piezoelectric yarn is wound around the inner conductor,
the piezoelectric yarn including an optically active polypeptide fiber that is a fiber including an optically active polypeptide, and
the piezoelectric layer having an elastic modulus Y of from 1.0 GPa to 8.0 GPa as measured by a microhardness measurement in accordance with JIS Z 2255.

<2> The piezoelectric base material according to <1>, wherein a longitudinal direction of the piezoelectric yarn is substantially parallel to a main orientation direction of the optically active polypeptide.

<3> The piezoelectric base material according to <1> or <2>, wherein the optically active polypeptide fiber has a degree of orientation F of from 0.50 to less than 1.00 as determined by the following Formula (a) based on X-ray diffractometry:

$$\text{Formula (a): degree of orientation } F = (180° - \alpha)/180°$$

wherein, in Formula (a), $\alpha$ is a half-width (°) of a peak derived from the orientation.

<4> The piezoelectric base material according to any one of <1> to <3>, wherein the piezoelectric yarn is helically wound in a single direction.

<5> The piezoelectric base material according to <4>, wherein a helix angle of from 20° to 70° is formed between an axial direction of the inner conductor and a longitudinal direction of the piezoelectric yarn.

<6> The piezoelectric base material according to any one of <1> to <5>, wherein the adhering section includes at least one selected from epoxy adhesives, urethane adhesives, vinyl acetate resin emulsion-type adhesives, ethylene vinyl acetate emulsion-type adhesives, acrylic resin emulsion-type adhesives, styrene-butadiene rubber latex-type adhesives, silicone resin adhesives, $\alpha$-olefin adhesives, vinyl chloride resin solvent-type adhesives, rubber adhesives, elastic adhesives, chloroprene rubber solvent-type adhesives, nitrile rubber solvent-type adhesives, or cyanoacrylate adhesives.

<7> The piezoelectric base material according to any one of <1> to <6>, further including an outer conductor at a peripheral side of the piezoelectric layer,
wherein the inner conductor is not electrically connected to the outer conductor.

<8> The piezoelectric base material according to any one of <1> to <7>, wherein the optically active polypeptide has a $\beta$-sheet structure.

<9> The piezoelectric base material according to any one of <1> to <8>, wherein the optically active polypeptide includes at least one of fibroin or spider silk protein.

<10> The piezoelectric base material according to any one of <1> to <9>, wherein the optically active polypeptide fiber includes at least one of silk or spider silk.

<11> The piezoelectric base material according to <10>, wherein the silk is refined silk.

<12> The piezoelectric base material according to any one of <1> to <11>, wherein:

each piezoelectric yarn includes a plurality of optically active polypeptide fibers, and
a number of twists of the piezoelectric yarn is not more than 500 T/m.

<13> The piezoelectric base material according to any one of <1> to <12>, further including an electrical insulator at an outermost periphery.

<14> A sensor, including the piezoelectric base material according to any one of <1> to <13>.

<15> An actuator, including the piezoelectric base material according to any one of <1> to <13>.

<16> A biological information acquisition device, including the piezoelectric base material according to any one of <1> to <13>.

<17> A piezoelectric base material, including:

an elongated inner conductor; and
a piezoelectric layer covering a periphery of the inner conductor,
the piezoelectric layer being formed by winding an elongated piezoelectric body around the inner conductor, and not being fixed to the inner conductor,

the elongated piezoelectric body including a plurality of piezoelectric yarns; and a bundling body for bundling the plurality of piezoelectric yarns, and

at least one of the plurality of piezoelectric yarns includeing an optically active polypeptide fiber that is a fiber including an optically active polypeptide.

<18> The piezoelectric base material according to <17>, wherein a longitudinal direction of the elongated piezoelectric body is substantially parallel to a main orientation direction of the optically active polypeptide.

<19> The piezoelectric base material according to <17> or <18>, wherein the optically active polypeptide fiber has a degree of orientation F of from 0.50 to less than 1.00 as determined by the following Formula (a) based on X-ray diffractometry:

$$\text{Formula (a): degree of orientation } F = (180°-\alpha)/180°$$

wherein, in Formula (a), $\alpha$ is a half-width (°) of a peak derived from the orientation.

<20> The piezoelectric base material according to any one of <17> to <19>, wherein the elongated piezoelectric body is helically wound in a single direction.

<21> The piezoelectric base material according to <20>, wherein a helix angle of from 20° to 70° is formed between an axial direction of the inner conductor and a longitudinal direction of the elongated piezoelectric body.

<22> The piezoelectric base material according to any one of <17> to <21>, wherein the bundling body bundles the plurality of piezoelectric yarns in a state in which the plurality of piezoelectric yarns are aligned parallel to each other along a direction perpendicular to a longitudinal direction of the plurality of piezoelectric yarns, and where piezoelectric yarns adjacent to each other among the plurality of piezoelectric yarns are in contact with each other.

<23> The piezoelectric base material according to any one of <17> to <22>, wherein the bundling body includes at least one selected from epoxy adhesives, urethane adhesives, vinyl acetate resin emulsion-type adhesives, ethylene vinyl acetate emulsion-type adhesives, acrylic resin emulsion-type adhesives, styrene-butadiene rubber latex-type adhesives, silicone resin adhesives, $\alpha$-olefin adhesives, vinyl chloride resin solvent-type adhesives, rubber adhesives, elastic adhesives, chloroprene rubber solvent-type adhesives, nitrile rubber solvent-type adhesives, or cyanoacrylate adhesives.

<24> The piezoelectric base material according to any one of <17> to <23>, wherein:

the elongated piezoelectric body has a thickness of from 0.001 mm to 0.4 mm,
the elongated piezoelectric body has a width of from 0.1 mm to 30 mm, and
a ratio of the width of the elongated piezoelectric body to the thickness of the elongated piezoelectric body is not less than 2.

<25> The piezoelectric base material according to any one of <17> to <24>, wherein the elongated piezoelectric body has an elastic modulus Y of from 1 GPa to 10 GPa as measured by a microhardness measurement in accordance with JIS Z 2255.

<26> The piezoelectric base material according to any one of <17> to <25>, further including an outer conductor at a peripheral side of the piezoelectric layer,wherein the inner conductor is not electrically connected to the outer conductor.

<27> The piezoelectric base material according to any one of <17> to <26>, wherein the optically active polypeptide has a $\beta$-sheet structure.

<28> The piezoelectric base material according to any one of <17> to <27>, wherein the optically active polypeptide includes at least one of fibroin or spider silk protein.

<29> The piezoelectric base material according to any one of <17> to <28>, wherein the fiber including an optically active polypeptide includes at least one of silk or spider silk.

<30> The piezoelectric base material according to <29>, wherein the silk is refined silk.

<31> The piezoelectric base material according to any one of <17> to <30>, wherein:

each of the plurality of piezoelectric yarns includes a plurality of the optically active polypeptide fibers, and
a number of twists of each of the plurality of piezoelectric yarns is not more than 500 T/m.

<32> The piezoelectric base material according to any one of <17> to <31>, further including an electrical insulator at an outermost periphery.

<33> A sensor, including the piezoelectric base material according to any one of <17> to <32>.

<34> An actuator, including the piezoelectric base material according to any one of <17> to <32>.

<35> A biological information acquisition device, including the piezoelectric base material according to any one of <17> to <32>.

Advantageous Effects of Invention

According to the disclosure, a piezoelectric base material, a sensor, an actuator, and a biological information acquisition device, having excellent piezoelectric sensitivity are provided.

According to the disclosure, efficient terminal-attachment preparation is possible, and in addition, a piezoelectric base material, a sensor, an actuator, and a biological information acquisition device, having excellent piezoelectric sensitivity are provided.

BRIEF DESCRIPTION OF DRAWINGS

Fig. 1A is a schematic side view showing an external appearance of a piezoelectric base material according to a first embodiment of a first aspect of the disclosure.
Fig. 1B is a cross-sectional view taken along the IB-IB line in Fig. 1A.
Fig. 2 is a schematic side view showing an external appearance of a piezoelectric base material according to a second embodiment of the first aspect of the disclosure.
Fig. 3A is a schematic side view showing an external appearance of a piezoelectric base material according to a first embodiment of a second aspect of the disclosure.
Fig. 3B is a schematic front view showing an external appearance of a long piezoelectric body according to the first embodiment of the second aspect of the disclosure.
Fig. 3C is a cross-sectional view taken along the IC-IC line in Fig. 3B.
Fig. 3D is a cross-sectional view taken along the ID-ID line in Fig. 3A.
Fig. 4 is a schematic side view showing an external appearance of a piezoelectric base material according to a second embodiment of the second aspect of the disclosure.

DETAILED DESCRIPTION

In the disclosure, each numerical range expressed using "from ... to ..." means the range including the values described before and after "to" as the lower limit and the upper limit, respectively.

(1) First Aspect

(1.1) Piezoelectric Base Material

A piezoelectric base material of a first aspect of the disclosure includes an elongated inner conductor, and a piezoelectric layer covering the periphery of the inner conductor. The piezoelectric layer includes a piezoelectric yarn wound around the inner conductor, and an adhering section that maintains a state in which the piezoelectric yarn is wound around the inner conductor. The piezoelectric yarn includes an optically active polypeptide fiber that is a fiber including an optically active polypeptide. The piezoelectric layer has an elastic modulus Y of from 1.0 GPa to 8.0 GPa as measured by a microhardness measurement in accordance with JIS Z 2255.

The longitudinal direction of the piezoelectric yarn is preferably substantially parallel to the main orientation direction of the optically active polypeptide.

The optically active polypeptide fiber preferably has a degree of orientation F of from 0.50 to less than 1.00 as determined by the following Formula (a) based on X-ray diffractometry:

$$\text{Formula (a): degree of orientation } F = (180° - \alpha)/180°$$

In Formula (a), $\alpha$ is a half-width (°) of a peak derived from the orientation.

In the disclosure, the term "piezoelectric yarn" means a yarn-shaped piezoelectric body.

In the disclosure, the term "optically active polypeptide" means a polypeptide including an asymmetric carbon atom, and having biased abundances of optical isomers.

In the disclosure, the term "substantially parallel" means that, when an angle formed between two segments is expressed within the range of from 0° to 90°, the angle formed between the two segments is 0° to less than 30° (preferably 0° to 22.5°, more preferably 0° to 10°, still more preferably 0° to 5°, particularly preferably 0° to 3°).

In the disclosure, the degree of orientation F of the piezoelectric yarn is an index indicating the degree of orientation of the optically active polypeptide included in the piezoelectric yarn.

Since the piezoelectric base material of the first aspect of the disclosure has the above configuration, it has higher piezoelectric sensitivity than those of conventional piezoelectric base materials such as the piezoelectric base material described in Patent Document 1.

(1.1.1) Piezoelectric Layer

The piezoelectric base material of the first aspect of the disclosure includes a piezoelectric layer.

The piezoelectric layer covers the periphery of the inner conductor. The piezoelectric layer preferably covers the entire periphery of the inner conductor.

The piezoelectric layer has an elastic modulus Y of from 1.0 GPa to 8.0 GPa. In cases where the piezoelectric layer has an elastic modulus Y within the range described above, the piezoelectric base material can have higher piezoelectric sensitivity.

In particular, from the viewpoint of improving the piezoelectric sensitivity of the piezoelectric base material, the elastic modulus Y of the piezoelectric layer is preferably within a first range or second range, more preferably within a second range.

The first range is from 1.0 GPa to 3.6 GPa, preferably from 1.5 GPa to 3.5 GPa, more preferably from 2.0 GPa to 3.4 GPa, still more preferably from 2.5 GPa to 3.3 GPa, particularly preferably from 2.5 GPa to 3.2 GPa.

The second range is from 4.0 GPa to 8.0 GPa, preferably from 4.2 GPa to 7.0 GPa, more preferably from 4.4 GPa to 6.5 GPa, still more preferably from 4.6 GPa to 6.0 GPa, particularly preferably from 4.9 GPa to 5.5 GPa.

The method of measuring the elastic modulus Y of the piezoelectric layer is the same as the measurement method described in the Examples.

Examples of the method for setting the elastic modulus Y of the piezoelectric layer within the range described above include a method in which the material of the adhering section included in the piezoelectric layer is controlled.

The thickness of the piezoelectric layer is not limited, and is preferably from 0.02 mm to 2.00 mm, more preferably from 0.05 mm to 1.00 mm.

The piezoelectric layer may or may not be fixed to the inner conductor.

In the disclosure, the term "fixed to the inner conductor" means that the piezoelectric layer is mechanically integrated with the inner conductor through an adhesive or the like.

In the disclosure, the term "not fixed to the inner conductor" means that the piezoelectric layer is not mechanically integrated with the inner conductor through an adhesive or the like.

In particular, the piezoelectric layer is preferably not fixed to the inner conductor. Compared to a configuration in which the piezoelectric layer is mechanically integrated with the inner conductor, the above configuration enables easier removal of the piezoelectric layer from the inner conductor during the later-described terminal-attachment preparation for the piezoelectric base material. Since, in this case, the inner conductor is not mechanically integrated with the piezoelectric layer, the inner conductor is less likely to be broken. As a result, the piezoelectric base material enables efficient terminal-attachment preparation for the piezoelectric base material.

In cases where a line sensor having a coaxial line structure is produced using the piezoelectric base material (for example, in cases of use as part of a wearable product or as the entire wearable product), the piezoelectric base material needs to be cut into a desired length in accordance with the mode of use, and a terminal needs to be attached to the piezoelectric base material. As a process before the attachment of the terminal, terminal-attachment preparation needs to be carried out. In the terminal-attachment preparation, the raw-silk layer and the copper foil ribbon layer are peeled off from both end portions of the piezoelectric base material, to expose the tinsel wire. More specifically, in the terminal-attachment preparation, the copper foil ribbon layer is peeled off from the raw-silk layer, and the raw-silk layer is removed for a length (normally about several millimeters) suitable for taking out the tinsel wire.

The piezoelectric layer can be displaced in the axial direction of the inner conductor with respect to the inner conductor. By this, compared to conventional piezoelectric base materials, the piezoelectric base material can be more easily deformed when an external stress acts on the piezoelectric base material. Thus, the internal stress of the piezoelectric base material caused by the action of the external stress is less likely to be locally concentrated. As a result, the piezoelectric base material can have excellent durability.

The piezoelectric layer includes a piezoelectric yarn and an adhering section. The piezoelectric yarn is wound around the inner conductor. The adhering section maintains the state in which the piezoelectric yarn is wound around the inner conductor.

The piezoelectric yarn may be directly wound on the periphery of the inner conductor. In cases where the later-described inner electrical insulator is placed on the periphery of the inner conductor, the piezoelectric yarn may be indirectly wound around the inner conductor by winding on the periphery of the inner electrical insulator.

The mode of winding of the piezoelectric yarn is not limited. The piezoelectric yarn may or may not be helically wound around the inner conductor with respect to the axial direction of the inner conductor. In particular, from the viewpoint of improving the piezoelectric sensitivity of the piezoelectric base material, the piezoelectric yarn is preferably helically wound around the inner conductor with respect to the axial direction of the inner conductor. The piezoelectric yarn may be wound in an overlapping manner, or may be wound in a non-overlapping manner.

In the piezoelectric base material of the first aspect of the disclosure, generation of an electric charge easily occurs upon application of a shear stress to the helically wound piezoelectric yarn. Therefore, the piezoelectric base material easily shows piezoelectricity.

The shear stress on the piezoelectric yarn can be applied by, for example, first nonplastic deformation, second nonplastic deformation, or third nonplastic deformation.

The term "first nonplastic deformation" means pulling of the entire helically wound piezoelectric yarn in the helix axis direction.

The term "second nonplastic deformation" means twisting of part of the helically wound piezoelectric yarn (in other words, twisting of part of the piezoelectric yarn with respect to the helix axis).

The term "third nonplastic deformation" means bending of part of the helically wound piezoelectric yarn, or the entire helically wound piezoelectric yarn.

The piezoelectric yarn is preferably helically wound in a single direction around the inner conductor.

The term "helically wound in a single direction" means a first winding aspect or second winding aspect.

The term "first winding aspect" means that the piezoelectric yarn is helically wound around the inner conductor such that, as seen from one end of the piezoelectric base material, the piezoelectric yarn is wound in a left-handed manner (that is, counterclockwise) from the near side to the far side.

The term "second winding aspect" means that the piezoelectric yarn is helically wound around the inner conductor such that, as seen from one end of the piezoelectric base material, the piezoelectric yarn is wound in a right-handed manner (that is, clockwise) from the near side to the far side.

In cases where the piezoelectric yarn is helically wound in a single direction, the phenomenon that the polarities of generated charges cancel each other (in other words, the phenomenon that the piezoelectricity decreases) can be suppressed. Therefore, the piezoelectric base material can have improved piezoelectricity.

Examples of aspects in which the piezoelectric base material includes a piezoelectric yarn helically wound in a single direction include not only an aspect in which the piezoelectric base material has only one layer including the piezoelectric yarn, but also an aspect in which the piezoelectric base material has a plurality of layers including the piezoelectric yarn, which layers are stacked on each other.

Examples of aspects in which a plurality of layers including the piezoelectric yarn are stacked on each other include an aspect in which, on a first layer including a piezoelectric yarn helically wound in a single direction, a second layer including a piezoelectric yarn is helically wound in the same direction as the single direction described above.

Examples of aspects of the piezoelectric base material also include an aspect including a first piezoelectric yarn helically wound in a single direction and a second piezoelectric yarn helically wound in a direction different from the single direction. In this aspect, the chirality of the optically active polypeptide included in the first piezoelectric yarn is different from the chirality of the optically active polypeptide included in the second piezoelectric yarn.

The helix angle is preferably from 20° to 70°, more preferably from 25° to 65°, still more preferably from 30° to 60°.

The term "helix angle" means the angle formed between the axial direction of the inner conductor and the longitudinal direction of the piezoelectric yarn. The method of measuring the helix angle is as follows. In cases where the piezoelectric base material includes the later-described outer conductor, the outer conductor of the piezoelectric base material is removed. The piezoelectric layer is then placed straight in the axial direction of the inner conductor, and a photograph is taken under an optical microscope. The angle of the piezoelectric yarn with respect to the axial direction of the inner conductor is measured by image processing at five points excluding sites showing extremely different angles. The measured values are averaged to calculate the helix angle.

(1.1.1.1) Piezoelectric Yarn

The piezoelectric yarn includes an optically active polypeptide fiber. The term "optically active polypeptide fiber" means a fiber including an optically active polypeptide. The inclusion of the optically active polypeptide in the piezoelectric yarn contributes to induction of piezoelectricity of the piezoelectric base material.

The piezoelectric yarn may be either a twisted yarn or non-twisted yarn. The piezoelectric yarn is particularly preferably a twisted yarn from the viewpoint of piezoelectricity. Examples of the non-twisted yarn include a single raw yarn (fiber), and an assembly of a plurality of raw yarns (fibers).

A number of raw yarns (fibers) forming the twisted yarn is not limited. From the viewpoint of securing strength of the piezoelectric yarn, the number is preferably from 3 to 120, more preferably from 4 to 30.

The raw yarns (fibers) forming the twisted yarn may include a fiber that is not an optically active polypeptide, as long as the raw yarns include at least one optically active polypeptide fiber. In particular, from the viewpoint of improving the piezoelectric sensitivity of the piezoelectric base material, the raw yarns (fibers) forming the twisted yarn preferably include only a plurality of optically active polypeptide fibers.

Each of the plurality of piezoelectric yarns includes a plurality of optically active polypeptide fibers, and the number of twists of each of the plurality of piezoelectric yarns is preferably not more than 500 T/m, more preferably not more than 300 T/m. In cases where the number of twists of each of the plurality of piezoelectric yarns is within this range, the piezoelectric yarns are less likely to be broken, and a higher piezoelectric sensitivity of the piezoelectric base material can be achieved.

The thickness of the piezoelectric yarn (in cases where the piezoelectric yarn is an assembly of a plurality of fibers, the thickness of the entire assembly) is not limited, and is preferably from 0.0001 mm to 2 mm, more preferably from 0.001 mm to 1 mm, still more preferably from 0.005 mm to 0.8 mm.

In cases where the piezoelectric yarn is a single raw yarn or an assembly of a plurality of raw yarns, the fineness of each raw yarn is preferably from 0.01 denier to 10,000 denier, more preferably from 0.1 denier to 1000 denier, still more preferably from 1 denier to 100 denier.

(1.1.1.1.1) Optically Active Polypeptide Fiber

The optically active polypeptide fiber is preferably a filament. By this, shear stress applied to the piezoelectric base material more easily transmits in the piezoelectric base material compared to cases where the optically active polypeptide fiber is a staple fiber. As a result, the piezoelectric base material can have improved piezoelectric sensitivity.

The term "filament" in the disclosure means a fiber having a length that enables continuous winding from one end to the other end in the longitudinal direction of the piezoelectric base material.

Any of silk (silk yarn), wool, mohair, cashmere, camel, llama, alpaca, vicuna, angora, or spider silk corresponds to a filament. Among the filaments, silk or spider silk is preferred from the viewpoint of piezoelectricity.

The optically active polypeptide fiber preferably has a degree of orientation F within the range of from 0.50 to less than 1.00.

In cases where the degree of orientation F of the optically active polypeptide fiber is not less than 0.50, it contributes to induction of piezoelectricity of the piezoelectric base material. In cases where the degree of orientation F of the optically active polypeptide fiber is less than 1.00, it contributes to productivity of the piezoelectric base material.

The degree of orientation F of the optically active polypeptide fiber is preferably from 0.50 to 0.99, more preferably from 0.70 to 0.98, still more preferably from 0.80 to 0.97.

In the optically active polypeptide fiber, a degree of orientation F of 1.00 means that the main orientation direction of the optically active polypeptide included in the optically active polypeptide fiber is parallel to the longitudinal direction of the optically active polypeptide fiber. In the optically active polypeptide fiber, a degree of orientation F of from 0.80 to less than 1.00 means that the main orientation direction of the optically active polypeptide included in the optically active polypeptide fiber is substantially parallel to the longitudinal direction of the optically active polypeptide fiber.

The degree of orientation F of the optically active polypeptide fiber is a value obtained by fixing, on a sample holder, a stack of piezoelectric yarns to be used as a reference axis, performing X-ray diffractometry to measure the azimuth angle distribution intensity found around the peak derived from the orientation, for example, around $2\theta=20°$ in the case of silk, and then performing calculation according to the following Formula (a):

$$\text{Formula (a): degree of orientation F} = (180°\text{-}\alpha)/180°$$

In Formula (a), $\alpha$ is the half-width (°) of the peak derived from the orientation.

The longitudinal direction of the piezoelectric yarn is preferably substantially parallel to the main orientation direction of the optically active polypeptide included in the piezoelectric yarn.

The substantially parallel positioning of the longitudinal direction of the piezoelectric yarn and the main orientation direction of the optically active polypeptide included in the piezoelectric yarn contributes to induction of piezoelectricity of the piezoelectric base material.

The substantially parallel positioning of the longitudinal direction of the piezoelectric yarn and the main orientation direction of the optically active polypeptide included in the piezoelectric yarn indicates that the piezoelectric yarn has excellent tensile strength for its longitudinal direction. Thus, the piezoelectric yarn is less likely to be broken during the helical winding of the piezoelectric yarn.

Regarding the cases where the piezoelectric yarn is silk or spider silk, the longitudinal direction of the piezoelectric yarn (silk or spider silk) becomes substantially parallel to the main orientation direction of the optically active polypeptide (for example, fibroin or spider silk protein) included in the piezoelectric yarn, during the process of generation of the silk or spider silk.

The substantially parallel positioning of the longitudinal direction of the piezoelectric yarn and the main orientation direction of the optically active polypeptide included in the piezoelectric yarn can be confirmed by comparing the direction of placement of the sample (piezoelectric yarn) and the azimuth angle of the crystal peak in X-ray diffractometry.

Examples of the method of achieving the substantially parallel positioning of the longitudinal direction of the piezoelectric yarn and the main orientation direction of the optically active polypeptide included in the piezoelectric yarn include a method using, as the piezoelectric yarn, a twisted yarn including a plurality of particular optically active polypeptide fibers. The term "particular optically active polypeptide fibers" means optically active polypeptide fibers having a degree of orientation F of from 0.80 to less than 1.00.

The optically active polypeptide preferably has a β-sheet structure from the viewpoint of piezoelectricity of the piezoelectric yarn and strength of the piezoelectric yarn.

Examples of the optically active polypeptide having a β-sheet structure include animal proteins having optical activity and synthetic proteins having optical activity.

Examples of the animal proteins having optical activity include fibroin, spider silk protein, sericin, collagen, keratin, and elastin. Examples of the spider silk protein include the spider silk protein described in Patent Document 1. As the spider silk protein, an artificial spider silk obtained by an artificial synthetic method may be used.

In particular, the optically active polypeptide preferably includes at least one of fibroin or spider silk protein, preferably includes fibroin.

Examples of the synthetic proteins having optical activity include synthetic spider silks (for example, "QMONOS (registered trademark)", synthetic bagworm silks, and synthetic proteins (such as "Brewed Protein (registered trademark)"). The synthetic protein having optical activity is preferably in the form of a yarn. A yarn-shaped fiber including a synthetic protein described above can be obtained also from a yarn, clothing, or the like containing "Brewed Protein (registered trademark)".

Examples of the optically active polypeptide fiber having a β-sheet structure include fibers including an animal protein having optical activity. Examples of the fibers including an animal protein having optical activity include silk, wool, mohair, cashmere, camel, llama, alpaca, vicuna, angora, and spider silk.

In particular, from the viewpoint of piezoelectricity, the optically active polypeptide fiber preferably includes at least one of silk or spider silk. The optically active polypeptide fiber is more preferably composed of at least one of silk or spider silk, particularly preferably composed of silk.

Examples of the silk include raw silk, refined silk, regenerated silk, and fluorescent silk.

The silk is preferably raw silk or refined silk, particularly preferably refined silk.

The term "refined silk" means a silk obtained by removing sericin from raw silk, which has a double structure of sericin and fibroin. The term "refinement" means an operation of removing sericin from raw silk. While raw silk has a matte white color, removal of sericin from (in other words, refinement of) raw silk changes the color from the matte white to glossy silvery white. Further, the refinement enhances soft texture.

(1.1.1.2) Adhering Section

The adhering section maintains the state in which the piezoelectric yarn is wound around the inner conductor.

Therefore, upon application of an external stress to the piezoelectric base material, shear stress due to the external stress can be easily allowed to act on the piezoelectric yarn.

The adhering section may cover the entire exposed surface of the piezoelectric yarn, or may cover part of the exposed surface of the piezoelectric yarn. In particular, from the viewpoint of improving the piezoelectric sensitivity of the piezoelectric base material, the adhering section preferably cover part of the exposed surface of the piezoelectric yarn.

The adhering section preferably includes at least one selected from epoxy adhesives, urethane adhesives, vinyl acetate resin emulsion-type adhesives, ethylene vinyl acetate emulsion-type adhesives, acrylic resin emulsion-type adhesives, styrene-butadiene rubber latex-type adhesives, silicone resin adhesives, α-olefin adhesives, vinyl chloride resin solvent-type adhesives, rubber adhesives, elastic adhesives, chloroprene rubber solvent-type adhesives, nitrile rubber solvent-type adhesives, or cyanoacrylate adhesives.

The material of the adhering section may be hereinafter referred to as "bundling agent".

The surface of the adhering section preferably has no irregularity thereon. For example, in cases where the surface of the adhering section has no irregularity, the later-described elongated conductor can be wound on the periphery of the piezoelectric layer to form an outer conductor while irregular winding of the elongated conductor is suppressed. Therefore, the absence of irregularity on the surface of the adhering section leads to improvement of the yield in the process of winding the elongated conductor. Further, occurrence of a decrease in the piezoelectric sensitivity due to irregular winding of the elongated conductor can be suppressed.

Examples of the method of preventing occurrence of irregularity on the surface of the adhering section include a method in which excessively supplied bundling agent is wiped off from the piezoelectric yarn wound around the inner conductor, before curing of the bundling agent supplied to the piezoelectric yarn wound around the inner conductor, and a method in which an adhesive containing a large amount of solvent is used as the bundling agent. The term "adhesive containing a large amount of solvent" means an adhesive in which the content of the resin component (solid component) is not more than 60% by mass with respect to the total amount of the adhesive.

(1.1.2) Inner Conductor

The piezoelectric base material of the first aspect of the disclosure includes an elongated inner conductor.

The inner conductor functions as a core of the piezoelectric base material.

The inner conductor is preferably a good conductor of electricity such as a copper wire, an aluminum wire, an SUS (Steel Use Stainless) wire, a metal wire coated with an insulation film, a carbon fiber, a resin fiber integrated with a carbon fiber, a tinsel wire, or an organic conductor material. The tinsel wire is formed by spirally winding copper foil around a fiber. The outer diameter of the fiber is appropriately controlled in accordance with desired properties of the piezoelectric base material, and is preferably from 0.1 mm to 10 mm.

In particular, from the viewpoint of improving the piezoelectric sensitivity and stability of the piezoelectric output, and giving high flexibility, the inner conductor is preferably a tinsel wire or a carbon fiber. A tinsel wire is particularly preferred since it has low electric resistance.

(1.1.3) Outer Conductor

The piezoelectric base material of the first aspect of the disclosure preferably further includes an outer conductor from the viewpoint of improving the piezoelectric sensitivity and the electrostatic shielding performance.

The outer conductor is placed at the outer-peripheral side of the piezoelectric layer. The inner conductor is not electrically connected to the outer conductor.

The outer conductor functions as, for example, a conductor paired with the inner conductor, for detection of an electric signal from the piezoelectric base material.

The outer conductor may cover at least part of the piezoelectric layer. More specifically, the outer conductor may cover part of the periphery of the piezoelectric layer, or may cover the entire periphery of the piezoelectric layer.

The outer conductor may or may not be fixed to the piezoelectric layer. The term "outer conductor is fixed to the piezoelectric layer" means that the outer conductor is mechanically integrated with the piezoelectric layer using a known adhesive.

In particular, the outer conductor is preferably not fixed to the piezoelectric layer. In this case, the outer conductor can be easily removed from the piezoelectric layer during the terminal-attachment preparation for the piezoelectric base material. Since the piezoelectric layer is not mechanically integrated with the outer conductor, the piezoelectric layer is less likely to be broken in this process. As a result, the piezoelectric base material enables more efficient terminal-attachment preparation for the piezoelectric base material.

Further, the outer conductor can be displaced in the axial direction of the inner conductor with respect to the piezoelectric layer. Therefore, compared to conventional piezoelectric base materials, the piezoelectric base material can be more easily deformed when an external stress acts on the piezoelectric base material. Thus, the internal stress of the piezoelectric base material caused by the action of the external stress is less likely to be locally concentrated. As a result, the piezoelectric base material has higher durability.

The outer conductor is formed by, for example, winding of an elongated conductor.

Examples of the cross-sectional shape of the elongated conductor include circular shapes, elliptical shapes, rectangular shapes, and irregular shapes. In particular, from the viewpoint of achieving planar adhesion to the piezoelectric base material to improve the piezoelectric sensitivity of the piezoelectric base material, the cross-sectional shape of the elongated conductor is preferably a rectangular shape.

The material of the elongated conductor is not limited, and examples of the material mainly include the following, depending on the cross-sectional shape.

Examples of the elongated conductor having a rectangular cross section include a copper foil ribbon prepared by flattening a copper wire having a circular cross section into a flat shape, and an aluminum foil ribbon.

Examples of the elongated conductor having a circular cross section include a copper wire, an aluminum wire, an SUS wire, a metal wire coated with an insulation film, a carbon fiber, a resin fiber integrated with a carbon fiber, and a tinsel wire formed by spirally winding copper foil around a fiber.

As the elongated conductor, an organic conductor material coated with an insulation material may be used.

The winding method for the elongated conductor includes a method in which copper foil or the like is helically wound around the piezoelectric base material, a method in which the piezoelectric base material is wrapped with a cylindrical braid prepared from a copper wire or the like, and a method by cylindrical clathration of the piezoelectric base material.

(1.1.4) Electrical Insulator

The piezoelectric base material of the first aspect of the disclosure may also include an electrical insulator (hereinafter referred to as "first insulator"). The first insulator is placed in the outermost periphery of the piezoelectric base material. In other words, at least part of the periphery of the piezoelectric base material is formed by the first insulator.

The first insulator preferably covers the entire outermost periphery of the piezoelectric base material. In other words, the entire periphery of the piezoelectric base material is preferably formed by the first insulator. In this case, electrostatic shielding of the inner conductor is possible. As a result, a change in the piezoelectric sensitivity due to external static electricity can be suppressed.

The first insulator is formed by, for example, helically winding an elongated object around the periphery of the outer conductor.

The material of the first insulator is not limited as long as the material has electrical insulating properties. Examples of the material include vinyl chloride resins, polyethylene resins, polypropylene resins, ethylene-tetrafluoroethylene copolymers (ETFEs), tetrafluoroethylene-hexafluoropropylene copolymers (FEPs), tetrafluoroethylene resins (PTFEs), tetrafluoroethylene-perfluoropropyl vinyl ether copolymers (PFAs), fluorocarbon rubbers, polyester resins, polyimide resins, polyamide resins, polyethylene terephthalate resins (PETs), and rubbers (including elastomers).

In cases where the piezoelectric base material of the first aspect of the disclosure includes an outer-peripheral conductor, the first insulator may or may not be fixed to the outer conductor. The term "first insulator is fixed to the outer conductor" means that the first insulator is mechanically integrated with the outer conductor using a known adhesive.

In particular, the first insulator is preferably not fixed to the outer conductor. In this case, the first insulator can be easily removed from the outer conductor during the terminal-attachment preparation for the piezoelectric base material. Since, in this case, the outer conductor is not mechanically integrated with the first insulator, the outer conductor is less likely to be broken. As a result, the piezoelectric base material enables more efficient terminal-attachment preparation for the piezoelectric base material.

Further, the first insulator can be displaced in the axial direction of the inner conductor with respect to the outer conductor. Therefore, compared to conventional piezoelectric base materials, the piezoelectric base material can be more easily deformed when an external stress acts on the piezoelectric base material. Thus, the internal stress of the piezoelectric base material caused by the action of the external stress is less likely to be locally concentrated. As a result, the piezoelectric base material has higher durability.

(1.1.5) Inner Electrical Insulator

In cases where the piezoelectric base material of the first aspect of the disclosure includes the outer conductor, the piezoelectric base material may also include an inner electrical insulator (hereinafter referred to as "second insulator"). The second insulator is placed at, for example, at least one of a position between the piezoelectric layer and the inner conductor, or a position between the piezoelectric layer and the outer conductor.

This enables better suppression of occurrence of short circuit between the inner conductor and the outer conductor.

The second insulator is formed by, for example, helically winding an elongated object around the periphery of the inner conductor.

Examples of the material of the second insulator include those exemplified as the material of the first insulator.

The second insulator may or may not be fixed to at least one of the inner conductor, piezoelectric layer, or outer conductor (hereinafter referred to as "inner conductor or the like"). The term "second insulator is fixed to the inner conductor or the like" means that the second insulator is mechanically integrated with the inner conductor or the like using a known adhesive. In particular, from the viewpoint of enabling more efficient terminal-attachment preparation for the piezoelectric base material, the second insulator is preferably not fixed to the outer conductor.

(1.1.6) Functional Layer

The piezoelectric base material of the first aspect of the disclosure may also include a functional layer. In cases where the piezoelectric base material does not include the outer conductor, the functional layer is placed between the piezoelectric layer and the inner conductor. In cases where the piezoelectric base material of the first aspect of the disclosure includes the outer conductor, the functional layer is placed at least one of a position between the piezoelectric layer and the inner conductor, or a position between the piezoelectric layer and the outer conductor.

Examples of a layer forming the functional layer (hereinafter referred to as "component layer") include an adhesion-promoting layer, a hard coating layer, a refractive-index control layer, an antireflection layer, an antiglare layer, a lubrication layer, an antiblock layer, a protective layer, an antistatic layer, a heat radiation layer, a UV-absorbing layer, an anti-Newton-ring layer, a light-scattering layer, a polarizing layer, a gas barrier layer, a hue control layer, and an electrode layer.

The functional layer may have a single-layer structure having a single component layer, or may have a multilayer structure having two or more component layers. In cases where the functional layer has a multilayer structure, the plurality of component layers may be the same component layers, or may be different component layers. In cases where the piezoelectric base material includes functional layers between the piezoelectric layer and the inner conductor and between the piezoelectric layer and the outer conductor, the functional layer between the piezoelectric layer and the inner conductor may be the same as or different from the functional layer between the piezoelectric layer and the outer conductor.

The film thickness of the functional layer is not limited, and preferably within the range of from 0.01 $\mu$m to 10 $\mu$m.

The material of the functional layer is appropriately selected in accordance with the function required for the functional layer, and examples of the material include inorganic substances such as metals and metal oxides; organic substances such as resins; and combined compositions containing a resin and a microparticle. Examples of the resins include cured products obtained by curing with a temperature or an active energy ray.

The functional layer may or may not be fixed to the inner conductor or the like. The term "functional tank is fixed to the inner conductor or the like" means that the second insulator is mechanically integrated with the inner conductor or the like using a known adhesive. In particular, from the viewpoint of enabling more efficient terminal-attachment preparation for the piezoelectric base material, the functional layer is preferably not fixed to the outer conductor.

Specific examples of the piezoelectric base material of the first aspect are described below with reference to drawings. However, the piezoelectric base material of the first aspect of the disclosure is not limited to the following specific examples.

In all of the drawings, the same symbols are assigned to substantially the same elements, and no redundant description is given to those elements.

(1.1.7) Piezoelectric Base Material According to First Embodiment of First Aspect

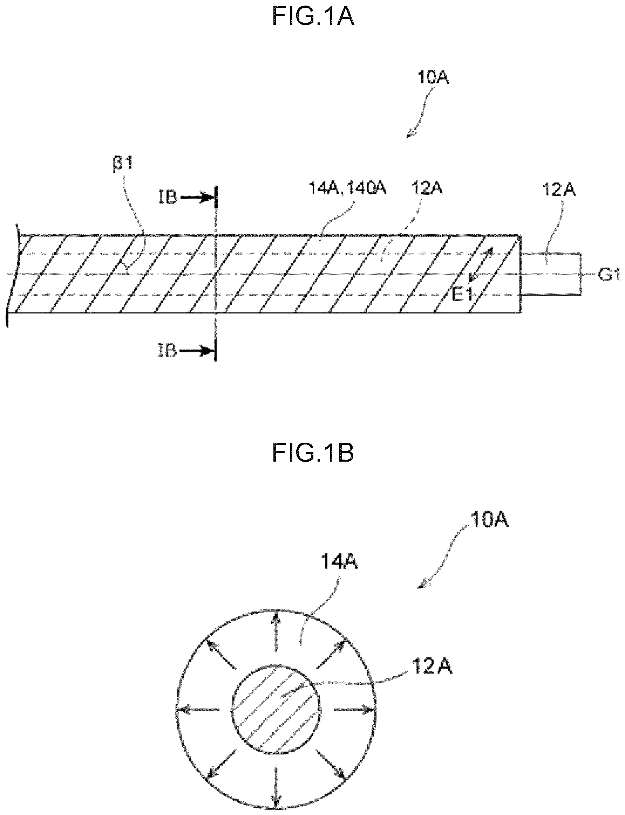

A piezoelectric base material 10A according to a first embodiment of the first aspect is described below with reference to Fig. 1A to Fig. 1D. Fig. 1A is a schematic side view showing an external appearance of the piezoelectric base material 10A according to the first embodiment of the first aspect of the disclosure. Fig. 1B is a cross-sectional view taken along the IB-IB line in Fig. 1A.

As shown in Fig. 1A, the piezoelectric base material 10A according to the first embodiment of the first aspect includes a long inner conductor 12A and a piezoelectric layer 14A. The piezoelectric layer 14A is helically wound in a single direction around the periphery of the inner conductor 12A at a helix angle $\beta1$ from one end to the other end such that no gap is formed. The piezoelectric layer 14A is not fixed to the inner conductor 12A.

The piezoelectric layer 14A is formed by winding a piezoelectric yarn 140A around the periphery of the inner conductor 12A in a left-handed manner with respect to the inner conductor 12A, and making an adhering section (not shown) maintaining the state in which the piezoelectric yarn 140A is wound around the inner conductor 12A. More specifically, as seen from one end side (right end side of Fig. 1A) in the axial direction of the inner conductor 12A of the piezoelectric base material 10A, the piezoelectric yarn 140A is wound in a left-handed manner from the near side to the far side of the inner conductor 12A. The piezoelectric yarn 140A includes an optically active polypeptide fiber.

The helix angle $\beta1$, in a side view, is an angle formed between the direction of the helix axis G1 (the axial direction of the inner conductor 12A) and the longitudinal direction of the piezoelectric yarn 140A.

The piezoelectric layer 14A has an elastic modulus Y (GPa) of from 1.0 GPa to 8.0 GPa.

Therefore, the piezoelectric base material 10A can have excellent piezoelectric sensitivity.

In Fig. 1A, the double-headed arrow E1 indicates the main orientation direction of the optically active polypeptide included in the piezoelectric layer 14A. Thus, in the first embodiment of the first aspect, the main orientation direction of the optically active polypeptide included in the piezoelectric yarn 140A is substantially parallel to the longitudinal direction of the piezoelectric yarn 140A.

An action effect of the piezoelectric base material 10A is described below.

When, for example, a tension is applied in the longitudinal direction of the piezoelectric base material 10A, a shear stress is applied to the optically active polypeptide included in the piezoelectric layer 14A, to cause polarization of the optically active polypeptide. The polarization of the optically active polypeptide is thought to occur due to phase synchronization in the diameter direction of the piezoelectric base material 10A as indicated by the arrows in Fig. 1B. By this, the piezoelectric base material 10A shows piezoelectricity. Further, the piezoelectric base material 10A can have excellent piezoelectric sensitivity.

(1.1.8) Piezoelectric Base Material According to Second Embodiment of First Aspect

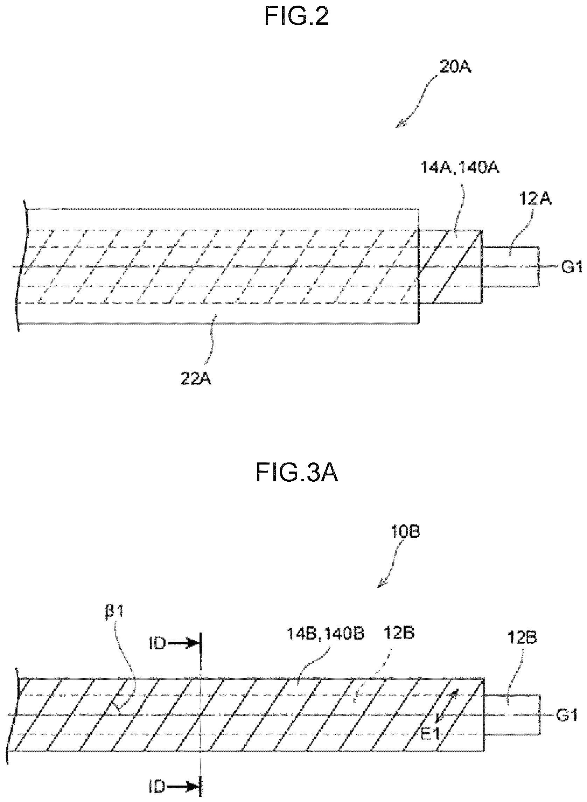

A piezoelectric base material 20A according to a second embodiment of the first aspect is described below with reference to Fig. 2. Fig. 2 is a schematic side view showing an external appearance of the piezoelectric base material 20A according to the second embodiment of the first aspect.

The piezoelectric base material 20A according to the second embodiment of the first aspect is different from the piezoelectric base material 10A according to the first embodiment of the first aspect in that the piezoelectric base material 20A includes an outer conductor 22A.

As shown in Fig. 2, the piezoelectric base material 20A according to the second embodiment of the first aspect includes an inner conductor 12A, a piezoelectric layer 14A, and an outer conductor 22A. The outer conductor 22A is placed at the outer-peripheral side relative to the piezoelectric layer 14A. The outer conductor 22A is formed by helically winding a copper foil ribbon around the piezoelectric yarn 140A (that is, on the periphery of the piezoelectric layer 14A), which piezoelectric yarn 140A is helically wound around (on the periphery of) the inner conductor 12A. The inner conductor 12A is not electrically connected to the outer conductor 22A.

As shown in Fig. 2, in the second embodiment of the first aspect, the end portion of the piezoelectric layer 14A (that is, the helically wound piezoelectric yarn 140A) and the end portion of the outer conductor 22A are differently positioned in the side view. By this, the inner conductor 12A and the outer conductor 22A can be securely insulated from each other. However, these end portions do not necessarily need to be differently positioned. As long as the inner conductor 12A and the outer conductor 22A are electrically insulated from each other, the positions of these end portions may overlap with each other in the side view.

The piezoelectric base material 20A produces an action effect similar to that of the piezoelectric base material 10A.

Further, since the piezoelectric base material 20A includes the inner conductor 12A, an electric signal (voltage signal or charge signal) generated in the piezoelectric layer 14A can be more easily extracted through the inner conductor 12A.

Further, since the piezoelectric base material 20A includes the outer conductor 22A, electrostatic shielding of the inside of the piezoelectric base material 20A (the piezoelectric layer 14A and the inner conductor 12A) is possible by the outer conductor 22A. Therefore, a voltage change in the inner conductor 12A due to the influence of external static electricity of the piezoelectric base material 20A can be suppressed, and, as a result, more stable piezoelectricity can be achieved.

(1.1.9) Use of Piezoelectric Base Material

Use of the piezoelectric base material of the first aspect of the disclosure is not limited, and examples of the use include force sensors, pressure sensors, displacement sensors, deformation sensors, motion sensors, vibration sensors, impact sensors, ultrasonic sensors, actuators, and energy harvesters.

The piezoelectric base material of the first aspect of the disclosure is applicable to the same uses as those of the piezoelectric base material described in Patent Document 1.

(1.2) Sensor

A sensor of the first aspect of the disclosure includes a piezoelectric base material of the first aspect of the disclosure.

Since the sensor of the first aspect of the disclosure includes the piezoelectric base material of the first aspect of the disclosure, the sensor has excellent piezoelectric sensitivity.

Examples of the sensor of the first aspect of the disclosure include force sensors, pressure sensors, displacement sensors, deformation sensors, motion sensors, vibration sensors, impact sensors, and ultrasonic sensors.

(1.3) Actuator

An actuator of the first aspect of the disclosure includes a piezoelectric base material of the first aspect of the disclosure.

Since the actuator of the first aspect of the disclosure includes the piezoelectric base material of the first aspect of the disclosure, the actuator has excellent piezoelectric sensitivity.

(1.4) Biological Information Acquisition Device

A biological information acquisition device of the first aspect of the disclosure includes a piezoelectric base material of the first aspect of the disclosure.

The biological information acquisition device of the first aspect of the disclosure uses the piezoelectric base material of the first aspect of the disclosure, to detect a biological signal of a human subject or subject animal (hereinafter collectively referred to as "subject"), to thereby acquire biological information of the subject.

Examples the biological signal include the presence or absence, body motions, pulse wave signals (heart beat signals), respiratory signals, body motion signals, ballistocardiac motions, and biological tremors. The term "biological tremor" means a rhythmical involuntary movement of a body part (such as a finger, a hand, a forearm, or an upper limb). The detection of the ballistocardiac motions include detection of an effect of a force exerted by cardiac function of the body. More specifically, when blood is pumped by the heart into the aorta and the pulmonary artery, the body receives a reaction force in the direction opposite to the blood flow. Changes in the strength and the direction of this reaction force occur in accordance with the functional stages of the heart. The reaction force is detected by sensing ballistocardiac motions on the outside of the body.

Examples of the article in which the biological information acquisition device of the first aspect of the disclosure is arranged include those in which the biological information acquisition device described in Patent Document 1 is arranged.

The biological information acquisition device of the first aspect of the disclosure may be used by inclusion in a seat, a steering device, a sheet, a seat belt, a shift knob, an armrest, a headrest, a steering wheel, or the like; or in clothing, a hat, or the like worn by a driver. The biological information acquisition device of the first aspect of the disclosure is preferably used as a detection section in an information processor. The information processor acquires a biological signal of a subject from the biological information acquisition device of the first aspect of the disclosure, and utilizes artificial intelligence (AI) to detect abnormality or health problem in the subject based on the acquired biological signal. The AI includes a learned model.

(2) Second Aspect

(2.1) Piezoelectric Base Material

A piezoelectric base material of a second aspect of the disclosure includes an elongated inner conductor, and a piezoelectric layer covering the periphery of the inner conductor. The piezoelectric layer is formed by winding an elongated piezoelectric body around the inner conductor, and is not fixed to the inner conductor. The elongated piezoelectric body includes a plurality of piezoelectric yarns, and a bundling body which bundles the plurality of piezoelectric yarns. At least one of the plurality of piezoelectric yarns includes an optically active polypeptide fiber that is a fiber including an optically active polypeptide.

The longitudinal direction of the elongated piezoelectric body is preferably substantially parallel to the main orientation direction of the optically active polypeptide.

The optically active polypeptide fiber preferably has a degree of orientation F of from 0.50 to less than 1.00 as determined by the following Formula (a) based on X-ray diffractometry:

$$\text{Formula (a): degree of orientation } F = (180° - \alpha)/180°$$

In Formula (a), $\alpha$ is the half-width (°) of the peak derived from the orientation.

In the disclosure, the term "not fixed to the inner conductor" means that the piezoelectric layer is not mechanically integrated with the inner conductor through an adhesive or the like.

The terms "piezoelectric yarn", "optically active polypeptide", and "substantially parallel" in the second aspect are the same as those in the first aspect.

In the disclosure, the degree of orientation F of the optically active polypeptide fiber is an index indicating the degree of orientation of the optically active polypeptide included in the piezoelectric yarn.

Since the piezoelectric base material of the second aspect of the disclosure has the above configuration, it enables more efficient terminal-attachment preparation, and has higher piezoelectric sensitivity, compared to conventional piezoelectric base materials such as the piezoelectric base material described in Patent Document 1.

(2.1.1) Piezoelectric Layer

The piezoelectric base material of the second aspect of the disclosure includes a piezoelectric layer.

The piezoelectric layer covers the periphery of the inner conductor. The piezoelectric layer preferably covers the entire periphery of the inner conductor.

The thickness of the piezoelectric layer is not limited, and preferably from 0.02 mm to 2.00 mm, more preferably from 0.05 mm to 0.50 mm. From the viewpoint of improving the piezoelectric sensitivity of the piezoelectric base material, the piezoelectric layer preferably has the same thickness as the elongated piezoelectric body.

The piezoelectric layer is not fixed to the inner conductor. Therefore, compared to a configuration in which the piezoelectric layer is mechanically integrated with the inner conductor, the above configuration enables easier removal of the piezoelectric layer from the inner conductor during the terminal-attachment preparation for the piezoelectric base material. Since, in this case, the inner conductor is not mechanically integrated with the piezoelectric layer, the inner conductor is less likely to be broken. As a result, the piezoelectric base material enables efficient terminal-attachment preparation for the piezoelectric base material.

Further, the piezoelectric layer can be displaced in the axial direction of the inner conductor with respect to the inner conductor. Therefore, compared to conventional piezoelectric base materials, the piezoelectric base material can be more easily deformed when an external stress acts on the piezoelectric base material. Thus, the internal stress of the piezoelectric base material caused by the action of the external stress is less likely to be locally concentrated. As a result, the piezoelectric base material can have higher durability than conventional piezoelectric base materials.

The piezoelectric layer is formed by winding an elongated piezoelectric body around the inner conductor.

The elongated piezoelectric body may be directly wound on the periphery of the inner conductor. In cases where the later-described inner electrical insulator is placed on the periphery of the inner conductor, the elongated piezoelectric body may be indirectly wound around the inner conductor by winding on the periphery of the inner electrical insulator.

The elongated piezoelectric body wound around the periphery of the inner conductor may be mechanically integrated as long as the piezoelectric layer is not fixed to the inner conductor. By this, the piezoelectric layer can have improved mechanical strength. Examples of the method of mechanically integrating the elongated piezoelectric body wound around the periphery of the inner conductor include a method in which a known adhesive is applied to the surface, in the side opposite to the inner conductor, of the elongated piezoelectric body wound around the periphery of the inner conductor, to fix and join the elongated piezoelectric body wound around the periphery of the inner conductor.

The mode of winding of the elongated piezoelectric body is not limited. The elongated piezoelectric body may or may not be helically wound around the inner conductor with respect to the axial direction of the inner conductor. In particular, from the viewpoint of improving the piezoelectric sensitivity of the piezoelectric base material, the elongated piezoelectric body is preferably helically wound around the inner conductor with respect to the axial direction of the inner conductor. The elongated piezoelectric body may be wound in an overlapping manner, or may be wound in a non-overlapping manner.

In the piezoelectric base material of the second aspect of the disclosure, generation of an electric charge easily occurs upon application of a shear stress to the helically wound elongated piezoelectric body. Therefore, the piezoelectric base material easily shows piezoelectricity.

The shear stress on the elongated piezoelectric body can be applied by, for example, first nonplastic deformation, second nonplastic deformation, or third nonplastic deformation.

The term "first nonplastic deformation" means pulling of the entire helically wound elongated piezoelectric body in the helix axis direction.

The term "second nonplastic deformation" means twisting of part of the helically wound elongated piezoelectric body (in other words, twisting of part of the elongated piezoelectric body with respect to the helix axis).

The term "third nonplastic deformation" means bending of part of the helically wound elongated piezoelectric body, or the entire helically wound elongated piezoelectric body.

The elongated piezoelectric body is preferably helically wound in a single direction around the inner conductor.

The term "helically wound in a single direction" in the second aspect has the same meaning as in the first aspect.

In cases where the elongated piezoelectric body is helically wound in a single direction, the phenomenon that the polarities of generated charges cancel each other (in other words, the phenomenon that the piezoelectricity decreases) can be suppressed. Therefore, the piezoelectric base material can have improved piezoelectricity.

Examples of aspects in which the piezoelectric base material includes an elongated piezoelectric body helically wound in a single direction include not only an aspect in which the piezoelectric base material has only one layer including the elongated piezoelectric body, but also an aspect in which the piezoelectric base material has a plurality of layers including the elongated piezoelectric body, which layers are stacked on each other.

Examples of aspects in which a plurality of layers including the elongated piezoelectric body are stacked on each other include an aspect in which, on a first layer including an elongated piezoelectric body helically wound in a single direction, a second layer including an elongated piezoelectric body is helically wound in the same direction as the single direction described above.

Examples of aspects of the piezoelectric base material also include an aspect including an first elongated piezoelectric body helically wound in a single direction and a second elongated piezoelectric body helically wound in a direction different from the single direction. In this aspect, the chirality of the optically active polypeptide included in the first elongated piezoelectric body is different from the chirality of the optically active polypeptide included in the second elongated piezoelectric body.

The helix angle is preferably from 20° to 70°, more preferably from 25° to 65°, still more preferably from 30° to 60°.

The term "helix angle" in the second aspect, and the measurement method for the helix angle are the same as those in the first aspect.

(2.1.1.1) Elongated Piezoelectric Body

The elongated piezoelectric body includes a plurality of piezoelectric yarns, and a bundling body. The bundling body bundles the plurality of piezoelectric yarns. The plurality of piezoelectric yarns bundled by the bundling body may be either aligned or randomly arranged. For example, the plurality of piezoelectric yarns may be bundled by the bundling body such that the plurality of piezoelectric yarns are intentionally aligned to have the same longitudinal direction, or may be randomly bundled by the bundling body.

The elongated piezoelectric body preferably has an elastic modulus Y of from 1 GPa to 10 GPa.

In order to allow shear stress to effectively act on the piezoelectric yarn upon deformation of the piezoelectric layer in the tensile direction, the bundling body needs to have a rigidity which makes the bundling body less deformable than the piezoelectric yarn. In cases where the elastic modulus Y of the elongated piezoelectric body is within the range described above, the stress exerted by application of an external stress to the piezoelectric layer is likely to be effectively transmitted to the piezoelectric yarn. In cases where the elongated piezoelectric body has an elastic modulus within the range described above, the piezoelectric base material can have improved piezoelectric sensitivity. Further, the piezoelectric base material can have higher durability, and enables more efficient terminal-attachment preparation for the piezoelectric base material.

From the viewpoint of the piezoelectric sensitivity of the piezoelectric base material, and processability in the winding of the elongated piezoelectric body, the elastic modulus Y of the elongated piezoelectric body is more preferably from 1 GPa to 10 GPa, still more preferably from 2 GPa to 10 GPa.

The elastic modulus Y of the elongated piezoelectric body is measured by microhardness measurement in accordance with JIS Z 2255. The microhardness measurement in accordance with JIS Z 2255 is carried out under measurement conditions at a temperature of $23 \pm 2°C$ and a humidity of $50 \pm 5°C$.

The elongated piezoelectric body may be in the shape of, for example, a ribbon. The term "ribbon shape" means a flat and elongated shape.

The size of the elongated piezoelectric body is not limited.

The elongated piezoelectric body preferably has a thickness of from 0.001 mm to 0.4 mm. The elongated piezoelectric body preferably has a width of from 0.1 mm to 30 mm. The ratio of the width of the elongated piezoelectric body to the thickness of the elongated piezoelectric body is preferably not less than 2.

From the viewpoint of the piezoelectric sensitivity of the piezoelectric base material, and the mechanical strength of the piezoelectric base material, the thickness of the elongated piezoelectric body is more preferably from 0.02 mm to 0.4 mm, still more preferably from 0.05 mm to 0.2 mm.

From the viewpoint of the piezoelectric sensitivity of the piezoelectric base material, and thinning of the piezoelectric base material, the width of the elongated piezoelectric body is more preferably from 0.1 mm to 5.0 mm, still more preferably from 0.4 mm to 1.0 mm.

From the viewpoint of the piezoelectric sensitivity of the piezoelectric base material, and thinning of the piezoelectric base material, the ratio of the width of the elongated piezoelectric body to the thickness of the elongated piezoelectric body is more preferably from 2 to 20, still more preferably from 3 to 10.

The positional relationship between the plurality of piezoelectric yarns and the bundling body in the elongated piezoelectric body is not limited. The bundling body preferably bundles the plurality of piezoelectric yarns in a state in which the plurality of piezoelectric yarns are aligned parallel to each other along the direction perpendicular to the longitudinal direction of the plurality of piezoelectric yarns, and where piezoelectric yarns adjacent to each other among the plurality of piezoelectric yarns are in contact with each other. In other words, a predetermined state of placement of the plurality of piezoelectric yarns is preferably maintained by the bundling body. The term "predetermined state" means a state in which the plurality of piezoelectric yarns are aligned parallel to each other along the direction perpendicular to the longitudinal direction of the plurality of piezoelectric yarns, and where piezoelectric yarns adjacent to each other among the plurality of piezoelectric yarns are in contact with each other. Therefore, the piezoelectric base material can have improved piezoelectric sensitivity.

A number of piezoelectric yarns is appropriately selected depending on the use or the like of the piezoelectric base material. From the viewpoint of processability, the number of piezoelectric yarns is preferably from 2 to 20, more preferably from 2 to 8.

The elongated piezoelectric body may be prepared by subjecting an elongated piezoelectric body precursor obtained as a wide product to a slitting process.

(2.1.1.1.1) Piezoelectric Yarn

At least one of the plurality of piezoelectric yarns includes an optically active polypeptide fiber. The inclusion of the optically active polypeptide in the piezoelectric yarn contributes to induction of piezoelectricity of the piezoelectric base material. Examples of the piezoelectric yarn of the second aspect include those exemplified as the piezoelectric yarn of the first aspect.

Each of the plurality of piezoelectric yarns includes a plurality of optically active polypeptide fibers, and the number of twists of each of the plurality of piezoelectric yarns is preferably not more than 500 T/m, more preferably not more than 300 T/m. In cases where the number of twists of each of the plurality of piezoelectric yarns is within this range, the piezoelectric yarns are less likely to be broken, and a higher piezoelectric sensitivity of the piezoelectric base material can be achieved.

(2.1.1.1.1.1) Optically Active Polypeptide Fiber

Examples of the optically active polypeptide fiber of the second aspect include those exemplified as the optically active polypeptide fiber of the first aspect.

The optically active polypeptide fiber preferably has a degree of orientation F within the range of from 0.50 to less than 1.00. The technical reason for setting the degree of orientation F within the above-described range, the preferred range of the degree of orientation F, and the method of measuring the degree of orientation F in the second aspect are the same as those in the first aspect.

The longitudinal direction of the elongated piezoelectric body is preferably substantially parallel to the main orientation direction of the optically active polypeptide included in the piezoelectric yarn.

The substantially parallel positioning of the longitudinal direction of the elongated piezoelectric body and the main orientation direction of the optically active polypeptide included in the piezoelectric yarn contributes to induction of piezoelectricity of the piezoelectric base material.

The substantially parallel positioning of the longitudinal direction of the elongated piezoelectric body and the main orientation direction of the optically active polypeptide included in the piezoelectric yarn indicates that the elongated piezoelectric body has excellent tensile strength for its longitudinal direction. Thus, the piezoelectric yarn is less likely to be broken during the helical winding of the elongated piezoelectric body.

For example, regarding the cases where the piezoelectric yarn is silk or spider silk, the longitudinal direction of the piezoelectric yarn (silk or spider silk) becomes substantially parallel to the main orientation direction of the optically active polypeptide (for example, fibroin or spider silk protein) included in the piezoelectric yarn, during the process of generation of the silk or spider silk.

The substantially parallel positioning of the longitudinal direction of the elongated piezoelectric body and the main orientation direction of the optically active polypeptide included in the piezoelectric yarn can be confirmed by comparing the direction of placement of the sample (elongated piezoelectric body) and the azimuth angle of the crystal peak in X-ray diffractometry.

Examples of the method of achieving the substantially parallel positioning of the longitudinal direction of the elongated piezoelectric body and the main orientation direction of the optically active polypeptide included in the piezoelectric yarn include a method in which the elongated piezoelectric body is prepared such that a plurality of particular piezoelectric yarns are placed parallel to each other along the direction perpendicular to the longitudinal direction of the particular piezoelectric yarns. The term "particular piezoelectric yarn" means a twisted yarn including a plurality of particular optically active polypeptide fibers. The term "particular optically active polypeptide fibers" means optically active polypeptide fibers having a degree of orientation F of from 0.80 to less than 1.00.

The optically active polypeptide preferably has a β-sheet structure from the viewpoint of piezoelectricity of the piezoelectric yarn and strength of the piezoelectric yarn.

The optically active polypeptide preferably includes at least one of fibroin or spider silk protein, preferably includes fibroin.

From the viewpoint of piezoelectricity, the optically active polypeptide fiber preferably includes at least one of silk or spider silk. The optically active polypeptide fiber is more preferably composed of at least one of silk or spider silk, particularly preferably composed of silk.

The silk is preferably raw silk or refined silk, particularly preferably refined silk.

(2.1.1.1.2) Bundling Body

The bundling body bundles a plurality of piezoelectric yarns. In other words, the bundling body integrates a plurality of piezoelectric yarns together.

Therefore, upon application of an external stress to the piezoelectric base material, shear stress due to the external stress can be easily allowed to act on the piezoelectric yarn.

The bundling body is not limited as long as it is capable of bundling a plurality of piezoelectric yarns, and examples of the bundling body include adhesive bodies and shrink films.

In cases where a shrink film is used as the bundling body, for example, a plurality of piezoelectric yarns are placed in a bag body formed with the shrink film, and the bag body is heated to cause the bag body to shrink, to obtain an elongated piezoelectric body.

In cases where an adhesive body is used as the bundling body, for example, a plurality of piezoelectric yarns are impregnated with an adhesive, and the plurality of piezoelectric yarns are fixed and joined together, to obtain an elongated piezoelectric body using the adhesive body. In this case, the adhesive body may cover the entire periphery of each of the plurality of piezoelectric yarns, or may cover part of the periphery of each of the plurality of piezoelectric yarns. In particular, the formation of the adhesive body may be limited to gap portions formed by the periphery where, among the plurality of piezoelectric yarns, piezoelectric yarns adjacent to each other are facing each other.

The bundling body (that is, adhesive body) preferably includes at least one selected from epoxy adhesives, urethane adhesives, vinyl acetate resin emulsion-type adhesives, ethylene vinyl acetate emulsion-type adhesives, acrylic resin emulsion-type adhesives, styrene-butadiene rubber latex-type adhesives, silicone resin adhesives, α-olefin adhesives, vinyl chloride resin solvent-type adhesives, rubber adhesives, elastic adhesives, chloroprene rubber solvent-type adhesives, nitrile rubber solvent-type adhesives, or cyanoacrylate adhesives. By this, the plurality of piezoelectric yarns can be integrated together to allow the plurality of piezoelectric yarns to function as the piezoelectric layer.

(2.1.2) Inner Conductor

The piezoelectric base material of the second aspect of the disclosure includes an elongated inner conductor.

Examples of the piezoelectric base material of the second aspect include those exemplified as the piezoelectric base material of the first aspect.

(2.1.3) Outer Conductor

The piezoelectric base material of the second aspect of the disclosure may further include an outer conductor from the viewpoint of improving the piezoelectric sensitivity and the electrostatic shielding performance. The outer conductor is placed at the outer-peripheral side of the piezoelectric layer. The inner conductor is not electrically connected to the outer conductor.

Examples of the outer conductor of the second aspect include those exemplified as the outer conductor of the first aspect.

(2.1.4) Electrical Insulator

The piezoelectric base material of the second aspect of the disclosure may also include an electrical insulator (hereinafter referred to as "first insulator"). The first insulator is placed at the outermost periphery of the piezoelectric base material. In other words, at least part of the periphery of the piezoelectric base material is formed by the first insulator.

Examples of the first insulator of the second aspect include those exemplified as the first insulator of the first aspect.

(2.1.5) Inner Electrical Insulator

In cases where the piezoelectric base material of the second aspect of the disclosure includes the outer conductor, the piezoelectric base material may also include an inner electrical insulator (hereinafter referred to as "second insulator"). The second insulator is placed at, for example, at least one of a position between the piezoelectric layer and the inner conductor, or a position between the piezoelectric layer and the outer conductor.

This enables better suppression of occurrence of short circuit between the inner conductor and the outer conductor.

Examples of the second insulator of the second aspect include those exemplified as the second insulator of the first aspect.

(2.1.6) Functional Layer

The piezoelectric base material of the second aspect of the disclosure may also include a functional layer. In cases where the piezoelectric base material of the second aspect of the disclosure does not include the outer conductor, the functional layer is placed between the piezoelectric layer and the inner conductor. In cases where the piezoelectric base material of the second aspect of the disclosure includes the outer conductor, the functional layer is placed at least one of a position between the piezoelectric layer and the inner conductor, or a position between the piezoelectric layer and the outer conductor.

Examples of the functional layer of the second aspect include those exemplified as the functional layer of the first aspect.

Specific examples of the piezoelectric base material of the second aspect are described below with reference to drawings. However, the piezoelectric base material of the second aspect of the disclosure is not limited to the following specific examples.

In all of the drawings, the same symbols are assigned to substantially the same elements, and no redundant description is given to those elements.

(2.1.7) Piezoelectric Base Material According to First Embodiment of Second Aspect

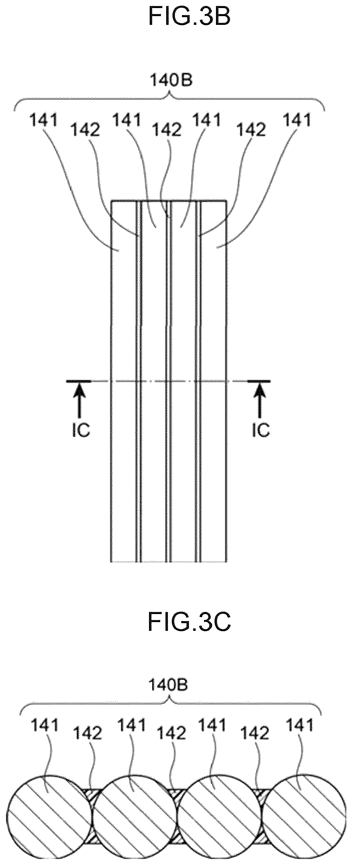

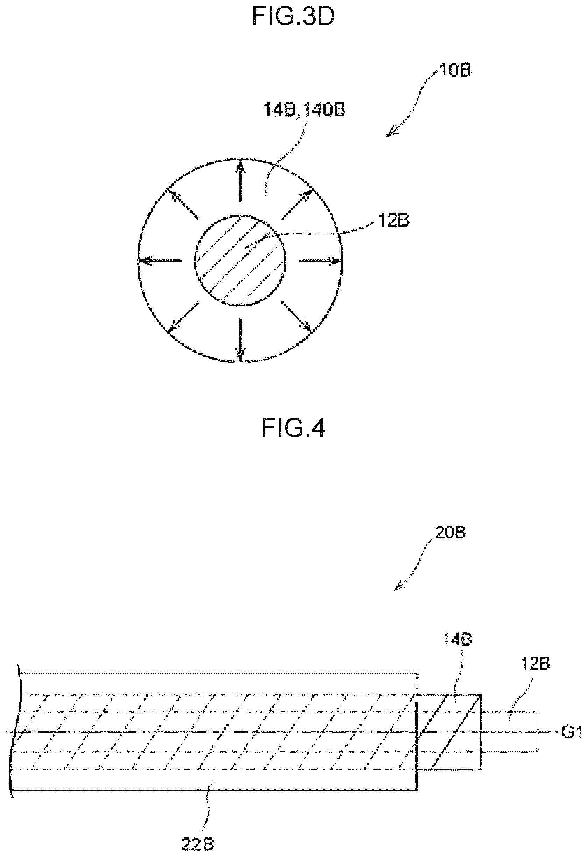

A piezoelectric base material 10B according to a first embodiment of the second aspect is described below with reference to Fig. 3A to Fig. 3D. Fig. 3A is a schematic side view showing an external appearance of the piezoelectric base material 10B according to the first embodiment of the second aspect of the disclosure. Fig. 3B is a schematic front view showing an external appearance of an elongated piezoelectric body 140B according to the first embodiment of the second aspect of the disclosure. Fig. 3C is a cross-sectional view taken along the IC-IC line in Fig. 3B. Fig. 3D is a cross-sectional view taken along the IC-IC line in Fig. 3A.

As shown in Fig. 3A, the piezoelectric base material 10B according to the first embodiment of the second aspect includes an elongated inner conductor 12B and a piezoelectric layer 14B. The piezoelectric layer 14B is helically wound in a single direction around the periphery of the inner conductor 12B at a helix angle $\beta1$ from one end to the other end such that no gap is formed. The piezoelectric layer 14B is not fixed to the inner conductor 12B.

The piezoelectric layer 14B is formed by winding the elongated piezoelectric body 140B around the periphery of the inner conductor 12B in a left-handed manner with respect to the inner conductor 12B. More specifically, as seen from one end side (right end side of Fig. 3A) in the axial direction of the inner conductor 12B of the piezoelectric base material 10B, the elongated piezoelectric body 140B is wound in a left-handed manner from the near side to the far side of the inner conductor 12B.

The helix angle $\beta1$, in a side view, is an angle formed between the direction of the helix axis G1 (the axial direction of the inner conductor 12B) and the longitudinal direction of the elongated piezoelectric body 140B.

As shown in Fig. 3B, the elongated piezoelectric body 140B includes four piezoelectric yarns 141, and a bundling body 142. In the first embodiment of the second aspect, each piezoelectric yarn 141 is a twisted yarn including a plurality of optically active polypeptides. The bundling body 142 includes a cyanoacrylate adhesive. The four piezoelectric yarns 141 are aligned parallel to each other along the direction perpendicular to the longitudinal direction of the piezoelectric yarns 141. Among the four piezoelectric yarns 141, adjacent piezoelectric yarns 141 are in contact with each other. The bundling body 142 maintains the above-described positions of the four piezoelectric yarns 141. More specifically, as shown in Fig. 3C, the bundling body 142 is formed only in gap portions formed by part of the periphery where, among the four piezoelectric yarns 141, piezoelectric yarns 141 adjacent to each other are facing each other.

By this, the piezoelectric base material 10B enables efficient terminal-attachment preparation.

In Fig. 3A, the double-headed arrow E1 indicates the main orientation direction of the optically active polypeptide included in the piezoelectric layer 14B. Thus, in the first embodiment of the second aspect, the main orientation direction of the optically active polypeptide is substantially parallel to the longitudinal direction of the elongated piezoelectric body 140B.

An action effect of the piezoelectric base material 10B is described below.

When, for example, a tension is applied in the longitudinal direction of the piezoelectric base material 10B, a shear stress is applied to the optically active polypeptide included in the piezoelectric layer 14B, to cause polarization of the optically active polypeptide. The polarization of the optically active polypeptide is thought to occur due to phase synchronization in the diameter direction of the piezoelectric base material 10B as indicated by the arrows in Fig. 3D. By this, the piezoelectric base material 10B shows piezoelectricity. Further, the piezoelectric base material 10B can have excellent piezoelectric sensitivity.

(2.1.8) Piezoelectric Base Material According to Second Embodiment of Second Aspect

A piezoelectric base material 20B according to a second embodiment of the second aspect is described below with reference to Fig. 4. Fig. 4 is a schematic side view showing an external appearance of the piezoelectric base material 20B according to the second embodiment of the second aspect.

The piezoelectric base material 20B according to the second embodiment of the second aspect is different from the piezoelectric base material 10B according to the first embodiment of the second aspect in that the piezoelectric base material 20B includes an outer conductor 22B.

As shown in Fig. 4, the piezoelectric base material 20B according to the second embodiment of the second aspect includes an inner conductor 12B, a piezoelectric layer 14B, and an outer conductor 22B. The outer conductor 22B is placed at the outer-peripheral side relative to the piezoelectric layer 14B. The outer conductor 22B is formed by helically winding a copper foil ribbon around the elongated piezoelectric body 140B (that is, on the periphery of the piezoelectric layer 14B), which elongated piezoelectric body 140B is helically wound around (on the periphery of) the inner conductor 12B. The inner conductor 12B is not electrically connected to the outer conductor 22B. The piezoelectric layer 14B is not fixed to the inner conductor 12B. The outer conductor 22B is not fixed to the piezoelectric layer 14B.

As shown in Fig. 4, in the second embodiment of the second aspect, the end portion of the piezoelectric layer 14B (that is, the helically wound elongated piezoelectric body 140B) and the end portion of the outer conductor 22B are differently positioned in the side view. By this, the inner conductor 12B and the outer conductor 22B can be securely insulated from each other. However, these end portions do not necessarily need to be differently positioned. As long as the inner conductor 12B and the outer conductor 22B are electrically insulated from each other, the positions of these end portions may overlap with each other in the side view.

The piezoelectric base material 20B produces an action effect similar to that of the piezoelectric base material 10B.

Further, since the piezoelectric base material 20B includes the inner conductor 12B, an electric signal (voltage signal or charge signal) generated in the piezoelectric layer 14B can be more easily extracted through the inner conductor 12B.

Further, since the piezoelectric base material 20B includes the outer conductor 22B, electrostatic shielding of the inside of the piezoelectric base material 20B (the piezoelectric layer 14B and the inner conductor 12B) is possible by the outer conductor 22B. Therefore, a voltage change in the inner conductor 12B due to the influence of external static electricity of the piezoelectric base material 20B can be suppressed, and, as a result, more stable piezoelectricity can be achieved.

(2.1.9) Use of Piezoelectric Base Material

Examples of use of the piezoelectric base material of the second aspect of the disclosure include those exemplified as use of the piezoelectric base material of the first aspect.

(2.2) Sensor

A sensor of the second aspect of the disclosure includes a piezoelectric base material of the second aspect of the disclosure.

Since the sensor of the second aspect of the disclosure includes the piezoelectric base material of the second aspect of the disclosure, the sensor has excellent piezoelectric sensitivity.

Examples of the sensor of the second aspect of the disclosure include force sensors, pressure sensors, displacement sensors, deformation sensors, motion sensors, vibration sensors, impact sensors, and ultrasonic sensors.

(2.3) Actuator

An actuator of the second aspect of the disclosure includes a piezoelectric base material of the second aspect of the disclosure.

Since the actuator of the second aspect of the disclosure includes the piezoelectric base material of the second aspect of the disclosure, the actuator has excellent piezoelectric sensitivity.

(2.4) Biological Information Acquisition Device

A biological information acquisition device of the second aspect of the disclosure includes a piezoelectric base material of the second aspect of the disclosure.

The biological information acquisition device of the second aspect of the disclosure uses the piezoelectric base material of the second aspect of the disclosure, to detect a biological signal of a human subject or subject animal (hereinafter collectively referred to as "subject"), to thereby acquire biological information of the subject.

Examples of the biological signal, the article in which the biological information acquisition device is arranged, and use of the biological information acquisition device, in the second aspect include those exemplified for the first aspect.

Examples

Embodiments according to the invention are described below in detail with reference to Examples. The invention is not limited by the descriptions of these Examples.

Example 1 to Example 4, and Comparative Example 1 to Comparative Example 4 correspond to the first aspect of the disclosure, and Example 5 and Comparative Example 5 correspond to the second aspect of the disclosure.

[Example 1]

<Providing of Optically Active Polypeptide Fiber>

As an optically active polypeptide fiber, raw silk was provided. Raw silk is a filament including an optically active polypeptide. The raw silk was a 21-denier raw silk. The raw silk had a thickness of from 0.06 mm to 0.04 mm.

(Measurement of Degree of Orientation F of Optically Active Polypeptide Fiber)

For measurement of the azimuth angle distribution intensity of the crystal plane peak [$2\theta=20°$], a wide-angle X-ray diffractometer ("RINT 2550", manufactured by Rigaku Corporation; attached equipment: rotary sample table; X-ray source: CuK$\alpha$; output: 40 kV 370 mA; detector: scintillation counter) was used. The measurement was carried out after fixing the raw silk (optically active polypeptide fiber) on a holder.
In the obtained azimuth angle distribution curve (X-ray interferogram), the degree of orientation F (degree of c-axis orientation) of the raw silk (optically active polypeptide fiber) was calculated from the half-width of the peak according to the following Formula (a).
The optically active polypeptide fiber had a degree of orientation F of 0.91.

$$\text{Formula (a): degree of orientation (F)} = (180°\text{-}\alpha)/180°$$

$\alpha$ is the half-width of the peak derived from the orientation.

<Preparation of Piezoelectric Yarn>

By a known method, the raw silk was prepared into refined silk while a single-twist yarn of six yarns (number of twists, 150 T/m) was provided as a piezoelectric yarn. The twisted yarn of the refined silk had a degree of orientation F of 0.86.
Since the optically active polypeptide fiber had a degree of orientation F of 0.86, and since the single-twist yarn (piezoelectric yarn) of six yarns was prepared using the refined silk, the longitudinal direction of the piezoelectric yarn and the main orientation direction of the optically active polypeptide included in the refined silk (optically active polypeptide fiber) can be judged to be substantially parallel to each other.

<Preparation of Two-Layered Piezoelectric Base Material>

As an inner conductor, a tinsel wire "U24-01-00", manufactured by Meisei Industry Co., Ltd. (wire diameter, 0.26 mm; length, 200 mm) was provided.
The piezoelectric yarn was wound on the periphery of the inner conductor at a helix angle of about 45° in a left-handed manner while formation of gaps was avoided as much as possible. By this, a layer (hereinafter referred to as "piezoelectric yarn layer") was formed on the periphery of the inner conductor, to obtain a piezoelectric base material precursor. The piezoelectric yarn layer covered the entire periphery of the inner conductor. Thus, the periphery of the inner conductor was not exposed.
The term "left-handed manner" means that, as seen from one end in the axial direction of the inner conductor (tinsel wire), the piezoelectric yarn is wound in a left-handed manner from the near side to the far side of the inner conductor. The term "helix angle" means the angle of the longitudinal direction of the piezoelectric yarn to the axial direction of the inner conductor.
As a bundling agent, "901H3" (a cyanoacrylate adhesive), manufactured by Toagosei Co., Ltd., was provided.
Onto the periphery of the piezoelectric yarn layer of the piezoelectric base material precursor, the bundling agent (cyanoacrylate adhesive) was added dropwise to allow infiltration of the bundling agent into the piezoelectric yarn. Immediately thereafter, excess bundling agent was wiped off from the periphery of the piezoelectric yarn using KIMWIPE, and then the piezoelectric base material precursor was left to stand at room temperature to cure the bundling agent. By this, a piezoelectric layer was formed from the piezoelectric yarn layer, to obtain a two-layered piezoelectric base material.
At this time, part of the piezoelectric layer was adhering to the inner conductor, but the piezoelectric layer was not fixed to the inner conductor. In other words, the piezoelectric layer and the inner conductor were not mechanically integrated together. Therefore, the piezoelectric layer could be easily removed from the inner conductor.
In order to determine the elastic modulus of the piezoelectric layer, part of the two-layered piezoelectric base material was cut to obtain a measurement sample (two-layered piezoelectric base material).

Using the measurement sample (two-layered piezoelectric base material), the elastic modulus of the piezoelectric layer was measured by the following method. The measurement result is shown in Table 1.

(Measurement of Elastic Modulus Y of Piezoelectric Layer)

The elastic modulus Y of the piezoelectric layer was measured as the indentation elastic modulus of the piezoelectric layer using a dynamic ultra-microhardness meter by a method in accordance with JIS Z 2255.

More specifically, the elastic modulus Y of the piezoelectric layer was evaluated by measurement in which an indenter was pushed from the periphery of the piezoelectric layer of the measurement sample (two-layered piezoelectric base material). The periphery of the piezoelectric layer of the measurement sample (two-layered piezoelectric base material) is a surface formed by impregnating the piezoelectric yarn layer, obtained by winding of the piezoelectric yarn on the periphery of the inner conductor, with a bundling agent, and curing the impregnated layer.

The apparatus used in this process was a dynamic ultra-microhardness meter "DUH-211R" (manufactured by Shimadzu Corporation). As the indenter, a diamond triangular pyramid indenter (ridge angle, 115°) was used. The measurement was carried out under soft sample measurement conditions at a temperature of 23 ± 2°C and a humidity of 50 ± 5°C.

The elastic modulus Y of the piezoelectric layer is a value evaluated from the degree of elastic recovery in the early phase of the unloading process, and is calculated using the following [Formula 1] to [Formula 4]. The elastic modulus Y used herein is a value calculated without taking the Poisson ratio of the measurement sample (two-layered piezoelectric base material) into account, that is, a value calculated by taking the Poisson ratio as 0.

[Formula 1]

$$Y = \frac{E}{1-v^2} = \frac{1}{1/E_r - (1-v_i^2)/E_i}$$

[Formula 2]

$$E_r = \frac{\sqrt{\pi}}{2\sqrt{A}} \times \frac{dP}{dh}$$

[Formula 3]

$$A = 23.97 \times h_c^2$$

[Formula 4]

$$h_c = h_{max} - 0.75 \times (h_{max} - h_r)$$

The symbols in [Formula 1] to [Formula 4] correspond to the following items.

"Y" is the elastic modulus (Pa) of the measurement sample including the Poisson ratio. The calculation result on the elastic modulus includes the difference in the shape of the indenter from the ideal shape.

"E" is the elastic modulus (Pa) of the measurement sample.

"$E_i$" is the elastic modulus of the diamond indenter ($1.14 \times 10^{12}$ Pa).

"$E_r$" is the composite elastic modulus (Pa) of the measurement sample and the indenter.

"v" is the Poisson ratio of the measurement sample.

"$v_i$" is the Poisson ratio (0.07) of the diamond indenter.

"A" is the indentation projected area ($m^2$).

"dP/dh" is the slope (N/m) at the start of unloading in the load-indentation depth diagram.

"$h_c$" is the effective contact depth (m).

"$h_{max}$" is the maximum indentation depth (m) (hereinafter referred to as "depth 1").
"$h_r$" is the point of intersection (m) between the tangent line at the start of unloading and the depth axis (hereinafter referred to as "depth 3").
"$h_{max}-h_r$" is (depth 1) - (depth 3).

<Preparation of Three-Layered Piezoelectric Base Material>

Part of the piezoelectric layer at both ends of the measurement sample (two-layered piezoelectric base material) after the measurement of the elastic modulus Y of the piezoelectric layer was removed to expose the inner conductor. In the state in which the inner conductor was exposed, crimp terminals were attached to both end portions of the measurement sample (piezoelectric base material). By this, a two-layered piezoelectric base material equipped with the terminals was obtained. The crimp terminals are used as fixation sections for evaluation of the piezoelectric sensitivity of the piezoelectric base material, and as terminals for taking out the inner electrode. The distance between the crimp terminals was adjusted to 150 mm.

As an outer conductor, a flattened copper foil ribbon having a rectangular cross-section was provided. The flattened copper foil ribbon had a width of 0.3 mm. The flattened copper foil ribbon had a thickness of 30 $\mu$m.

The flattened copper foil ribbon was wound, in a right-handed manner, on the periphery of the piezoelectric layer of the two-layered piezoelectric base material equipped with terminals, such that no gaps were formed to cause exposure of the piezoelectric layer. By this, a three-layered piezoelectric base material was obtained. The outer conductor covered the entire periphery of the piezoelectric layer. Thus, the periphery of the piezoelectric layer was not exposed. The outer conductor was not fixed to the piezoelectric layer by an adhesive or the like.

The three-layered piezoelectric base material was thus prepared.

(Measurement of Amount of Charge Generated per Unit Tensile Force (Piezoelectric Sensitivity))

The amount of charge generated upon application of a tensile force to the three-layered piezoelectric base material (amount of generated charge) was measured by the following method, and the amount of generated charge per unit tensile force (piezoelectric sensitivity) was calculated from the amount of generated charge. The measurement result is shown in Table 1.

More specifically, the three-layered piezoelectric base material was chucked in a tensile tester (Tensilon RTG 1250, manufactured by A&D Company, Ltd.) with a chuck distance of 50 mm.

Subsequently, using the tensile tester, tensions were periodically and repeatedly applied at 0.5 Hz in the form of triangular waves to the three-layered piezoelectric base material within a stress range of from 1.0 N to 2.0 N while measuring the amounts of charges generated on both sides of the three-layered piezoelectric base material using an electrometer (programmable electric meter "617", manufactured by Keithley Instruments, Inc.).

As the piezoelectric sensitivity of the three-layered piezoelectric base material, the amount of generated charge per unit tensile force was calculated from the slope of a correlation line in a scatter diagram obtained by plotting the measured amount of generated charge Q [C] on the Y-axis, and plotting the tensile force F [N] of the three-layered piezoelectric base material on the X-axis.

The results of measurement of the elastic modulus Y of the piezoelectric layer, and the piezoelectric sensitivity of the three-layered piezoelectric base material, are shown in Table 1.

[Example 2]

A three-layered piezoelectric base material was prepared and evaluated in the same manner as in Example 1 except that a two-layered piezoelectric base material was obtained as follows using a bundling agent (polyurethane adhesive A) instead of the bundling agent (cyanoacrylate adhesive). The results of measurement of the elastic modulus Y of the piezoelectric layer, and the piezoelectric sensitivity of the three-layered piezoelectric base material, are shown in Table 1.

In Example 2, the two-layered piezoelectric base material was prepared as follows.

A solution of a polyurethane resin (MT-OLESTER M37-50SS, manufactured by Mitsui Chemicals, Inc.) was diluted by addition of MEK thereto to adjust the solid content of the solution to 25% by mass, to obtain a bundling agent (polyurethane adhesive A). In the same manner as in Example 1, a piezoelectric base material precursor was obtained. A masking tape was attached to the terminal sections for attachment of crimp terminals at both end portions of the piezoelectric base material precursor. The entire piezoelectric yarn layer of the piezoelectric base material precursor was immersed for 3 minutes in a tank filled with the bundling agent (polyurethane adhesive A). Thereafter, the piezoelectric base material precursor was removed from the tank filled with the bundling agent (polyurethane adhesive A), and dripping portions of the piezoelectric base material precursor (where the bundling agent (polyurethane adhesive A) was dripping from the piezoelectric base material precursor) were wiped with KIMWIPE. Thereafter, the piezoelectric base material precursor was dried in a dryer at 150°C for 30 minutes. By this, a two-layered piezoelectric base material was obtained.

[Example 3]

A three-layered piezoelectric base material was prepared and evaluated in the same manner as in Example 2 except that a bundling agent (melamine adhesive) obtained by diluting a melamine resin solution (manufactured by Mitsui Chemicals, Inc.) with an n-BuOH solution to a solid content of 30% by mass was used instead of the bundling agent (polyurethane adhesive A). The results of measurement of the elastic modulus Y of the piezoelectric layer, and the piezoelectric sensitivity of the three-layered piezoelectric base material, are shown in Table 1.

[Example 4]

<Providing of Optically Active Polypeptide Fiber>

As an optically active polypeptide fiber, a wool yarn containing a synthetic protein ("Brewed Protein (registered trademark)" was provided. The content of the synthetic protein was 30% by mass with respect to the mass of the wool yarn. The thickness of the wool yarn containing the synthetic protein was about from 0.5 mm to 0.7 mm.

(Measurement of Degree of Orientation F of Optically Active Polypeptide Fiber)

<Preparation of Piezoelectric Yarn>

The degree of orientation F of the piezoelectric yarn, that is, the wool yarn containing the synthetic protein, was measured using X-ray diffractometry in the same manner as in Example 1. As a result of measurement of a peak near $2\theta=9°$ as a peak showing the orientation, the degree of orientation F was found to be 0.58.

A two-layered piezoelectric base material and a three-layered piezoelectric base material were prepared and evaluated in the same manner as in Example 1 except that, as the piezoelectric yarn, a single wool yarn containing the synthetic protein was used instead of the single-twist yarn of six yarns using refined silk. The results of measurement of the elastic modulus Y of the piezoelectric layer, and the piezoelectric sensitivity of the three-layered piezoelectric base material, are shown in Table 2.

[Comparative Example 1]

A three-layered piezoelectric base material was prepared and evaluated in the same manner as in Example 1 except that the cyanoacrylate adhesive "201" (manufactured by Toagosei Co., Ltd.) was used as a bundling agent (cyanoacrylate adhesive) instead of the bundling agent ("901H3"). The results of measurement of the elastic modulus Y of the piezoelectric layer, and the piezoelectric sensitivity of the three-layered piezoelectric base material, are shown in Table 1.

[Comparative Example 2]

A three-layered piezoelectric base material was prepared and evaluated in the same manner as in Example 2 except that a bundling agent (polyurethane adhesive B) prepared as follows was used instead of the bundling agent (polyurethane adhesive A). The results of measurement of the elastic modulus Y of the piezoelectric layer, and the piezoelectric sensitivity of the three-layered piezoelectric base material, are shown in Table 1.

The bundling agent in Comparative Example 2 (polyurethane adhesive B) was prepared as follows.

A mixed solution was obtained by mixing "TAKELAC A-3210" (manufactured by Mitsui Chemicals, Inc.) and "TAKENATE A-3070" (manufactured by Mitsui Chemicals, Inc.) at a mass ratio of 1:1. Thereafter, the mixed solution was diluted with ethyl acetate to adjust the solid content of the solution to 20% by mass, to obtain the bundling agent (polyurethane adhesive B).

[Comparative Example 3]

A three-layered piezoelectric base material was prepared and evaluated in the same manner as in Example 2 except that the polyurethane adhesive C "TAKENATE 6335" was used instead of the bundling agent (polyurethane adhesive A). The results of measurement of the elastic modulus Y of the piezoelectric layer, and the piezoelectric sensitivity of the three-layered piezoelectric base material, are shown in Table 1.

[Comparative Example 4]

A three-layered piezoelectric base material was prepared and evaluated in the same manner as in Example 4 except that the cyanoacrylate adhesive "201" (manufactured by Toagosei Co., Ltd.) was used instead of the bundling agent ("901H3"). The results of measurement of the elastic modulus Y of the piezoelectric layer, and the piezoelectric sensitivity of the three-layered piezoelectric base material, are shown in Table 2.

<Evaluation of Deterioration upon Application of Load>

The three-layered piezoelectric base material of Example 1, having a total length of 150 mm, was set to the tensile tester used for the measurement of the piezoelectric sensitivity. Deterioration caused by application of a load to the three-layered piezoelectric base material was evaluated. More specifically, in the tensile tester to which the three-layered piezoelectric base material was set, a crosshead was manually slowly moved in the tensile direction, and fixed at the position corresponding to a tensile load of 0.2 N. This position was set to the displacement reference point zero, and an operation of pulling the material 2 mm from this position and returning it to the zero position was repeated 100 times. The crosshead speed in this process was set to 30 mm/sec.
Before and after this test, sensitivity evaluation was carried out by application of a load of from 1 N to 2 N in the same manner as in Example 1. The sensitivity change was calculated by dividing the sensitivity after the test by the sensitivity before the test.
The same test was carried out using the three-layered piezoelectric base material of Example 2 or the three-layered piezoelectric base material of Comparative Example 1. The sensitivity change was calculated for each of these.
The sensitivity change of the three-layered piezoelectric base material of Example 1 was 1.00. The sensitivity change of the three-layered piezoelectric base material of Example 2 was 0.98. The sensitivity change of the three-layered piezoelectric base material of Comparative Example 1 was 0.80.
As a result, while the three-layered piezoelectric base materials of Example 1 and Example 2 showed only small changes in the sensitivity, the three-layered piezoelectric base material of Comparative Example 1 showed a large decrease in the sensitivity.

[Table 1]

| | Piezoelectric layer | | Elastic modulus Y of piezoelectric layer (GPa) | Evaluation result |
| | Piezoelectric yarn | Bundling body | | Piezoelectric sensitivity (pC/N·mm) |
| | Optically active polypeptide fiber | | | |
|---|---|---|---|---|
| Example 1 | Raw silk | Cyanoacrylate adhesive "901H3" | 5.1 | 5.0 |
| Example 2 | Raw silk | Polyurethane adhesive A | 3.1 | 4.2 |
| Example 3 | Raw silk | Melamine adhesive | 3.8 | 2.6 |
| Comparative Example 1 | Raw silk | Cyanoacrylate adhesive "201" | 8.5 | 2.3 |
| Comparative Example 2 | Raw silk | Polyurethane adhesive B | 0.2 | 1.3 |
| Comparative Example 3 | Raw silk | Polyurethane adhesive C "6335" | 0.7 | 1.1 |

[Table 2]

| | Piezoelectric layer | | Elastic modulus Y of piezoelectric layer (GPa) | Evaluation result |
| | Piezoelectric yarn | Bundling body | | Piezoelectric sensitivity (pC/N·mm) |
| | Optically active polypeptide fiber | | | |
| Example 4 | Wool yarn containing synthetic protein | Cyanoacrylate adhesive "901H3" | 6.2 | 0.32 |
| Comparative Example 4 | Wool yarn containing synthetic protein | Cyanoacrylate adhesive "201" | 10.4 | 0.14 |

The piezoelectric base materials of Comparative Example 1 to Comparative Example 3 include an elongated inner conductor, and a piezoelectric layer covering the periphery of the inner conductor. The piezoelectric layer includes a piezoelectric yarn wound around the periphery of the inner conductor, and an adhering section that maintains a state in which the piezoelectric yarn is wound around the periphery of the inner conductor. The piezoelectric yarn includes refined silk, which is an optically active polypeptide fiber. However, the elastic modulus Y of the piezoelectric layer was not within the range of from 1.0 GPa to 8.0 GPa.

Therefore, the piezoelectric sensitivity of each of the piezoelectric base materials of Comparative Example 1 to Comparative Example 3 was not more than 2.3 pC/N/mm. As a result, the piezoelectric base materials of Comparative Example 1 to Comparative Example 3 were found not to have excellent piezoelectric sensitivity.

The piezoelectric base materials of Example 1 to Example 3 include an elongated inner conductor, and a piezoelectric layer covering the periphery of the inner conductor. The piezoelectric layer includes a piezoelectric yarn wound around the periphery of the inner conductor, and an adhering section that maintains a state in which the piezoelectric yarn is wound around the periphery of the inner conductor. The piezoelectric yarn includes refined silk, which is an optically active polypeptide fiber. The elastic modulus Y of the piezoelectric layer was within the range of from 1.0 GPa to 8.0 GPa.

Therefore, the piezoelectric sensitivity of each of the piezoelectric base materials of Example 1 to Example 3 was higher than those of Comparative Example 1 to Comparative Example 3, and was not less than 2.6 pC/N/mm. As a result, the piezoelectric base materials of Example 1 to Example 3 were found to have excellent piezoelectric sensitivity.

Regarding comparison between the piezoelectric base material of Example 1 and the piezoelectric base material of Example 2, the elastic modulus Y of the piezoelectric layer of Example 1 was within the range of from 4.0 GPa to 8.0 GPa. Therefore, the piezoelectric sensitivity of Example 1 was higher than that of Example 2, and was 5.0 pC/N/mm.

On the other hand, regarding comparison between the piezoelectric base material of Example 3 and the piezoelectric base material of Example 2, the elastic modulus Y of the piezoelectric layer of Example 3 was within the range of from 1.0 GPa to 3.6 GPa. Therefore, the piezoelectric sensitivity of Example 3 was higher than that of Example 2, and was 4.2 pC/N/mm.

The piezoelectric base material of Comparative Example 4 includes an elongated inner conductor, and a piezoelectric layer covering the periphery of the inner conductor. The piezoelectric layer includes a piezoelectric yarn wound around the periphery of the inner conductor, and an adhering section that maintains a state in which the piezoelectric yarn is wound around the periphery of the inner conductor. The piezoelectric yarn includes a wool yarn containing a synthetic protein, which is an optically active polypeptide fiber. However, the elastic modulus Y of the piezoelectric layer was not within the range of from 1.0 GPa to 8.0 GPa.

Therefore, the piezoelectric sensitivity of the piezoelectric base material of Comparative Example 4 was not more than 0.14 pC/N/mm. As a result, the piezoelectric base material of Comparative Example 4 was found not to have excellent piezoelectric sensitivity.

The piezoelectric base material of Example 4 includes an elongated inner conductor, and a piezoelectric layer covering the periphery of the inner conductor. The piezoelectric layer includes a piezoelectric yarn wound around the periphery of the inner conductor, and an adhering section that maintains a state in which the piezoelectric yarn is wound around the periphery of the inner conductor. The piezoelectric yarn includes a wool yarn containing a synthetic protein, which is an optically active polypeptide fiber. The elastic modulus Y of the piezoelectric layer was within the range of from 1.0 GPa to 8.0 GPa.

Therefore, the piezoelectric sensitivity of the piezoelectric base material of Example 4 was higher than that of Comparative Example 4, and was not less than 0.32 pC/N/mm. As a result, the piezoelectric base material of Example 4 was found to have excellent piezoelectric sensitivity.

[Example 5]

<Providing of Optically Active Polypeptide Fiber>

As an optically active polypeptide fiber, raw silk was provided. Raw silk is a filament including an optically active polypeptide. The raw silk was a 21-denier raw silk. The raw silk had a thickness of from 0.06 mm to 0.04 mm.

(Measurement of Degree of Orientation F of Optically Active Polypeptide Fiber)

For measurement of the azimuth angle distribution intensity of the crystal plane peak [$2\theta=20°$], a wide-angle X-ray diffractometer ("RINT 2550", manufactured by Rigaku Corporation; attached equipment: rotary sample table; X-ray source: CuK$\alpha$; output: 40 kV 370 mA; detector: scintillation counter) was used. The measurement was carried out after fixing the raw silk (optically active polypeptide fiber) on a holder.

In the obtained azimuth angle distribution curve (X-ray interferogram), the degree of orientation F (degree of c-axis orientation) of the raw silk (optically active polypeptide fiber) was calculated from the half-width ($\alpha$) of the peak according to the following Formula (a).

The optically active polypeptide fiber had a degree of orientation F of 0.91.

$$\text{Formula (a): degree of orientation (F)} = (180°-\alpha)/180°$$

$\alpha$ is the half-width of the peak derived from the orientation.

<Preparation of Piezoelectric Yarn>

By a known method, the raw silk was prepared into refined silk while a single-twist yarn of six yarns (number of twists, 150 T/m) was provided as a piezoelectric yarn. The twisted yarn of the refined silk had a degree of orientation F of 0.86.

$$\text{Degree of orientation (F)} = (180°-\alpha)/180° \ ... \ \text{Formula (a)}$$

$\alpha$ is the half-width of the peak derived from the orientation.

<Preparation of Elongated Piezoelectric Body>

As an adhesive, "ARON ALPHA 901H3" (a cyanoacrylate adhesive), manufactured by Toagosei Co., Ltd., was provided.

Four piezoelectric yarns were aligned side by side in contact with each other such that the four piezoelectric yarns do not overlap with each other. More specifically, four piezoelectric yarns were aligned parallel to each other along the direction perpendicular to the longitudinal direction of the piezoelectric yarns, such that adjacent piezoelectric yarns, among the four yarns, were in contact with each other. In this state, the adhesive was added dropwise to the four piezoelectric yarns, to impregnate the four piezoelectric yarns with the adhesive. The four piezoelectric yarns were fixed and joined together by the adhesive. By this, an elongated piezoelectric body was obtained. The elongated piezoelectric body includes the four piezoelectric yarns, and the adhesive body bundling the four piezoelectric yarns. The adhesive body covered the entire periphery of the four piezoelectric yarns.

The elongated piezoelectric body was subjected to heat treatment at 120°C for 6 hours. The obtained elongated piezoelectric body had a thickness of 0.08 mm. The elongated piezoelectric body had a width of 0.65 mm. The ratio of the width of the elongated piezoelectric body to the thickness of the elongated piezoelectric body was 8.1.

Since the optically active polypeptide fiber had a degree of orientation F of 0.91, since the single-twist yarn (piezoelectric yarn) of six yarns prepared using the refined silk had a degree of orientation of 0.86, and since the elongated piezoelectric body was prepared by aligning the four piezoelectric yarns along the direction perpendicular to the longitudinal direction of the piezoelectric yarns, the longitudinal direction of the elongated piezoelectric body and the main orientation direction of the optically active polypeptide included in the refined silk (optically active polypeptide fiber) can be judged to be substantially parallel to each other.

<Preparation of Two-Layered Piezoelectric Base Material>

As an inner conductor, a tinsel wire "U24-01-00", manufactured by Meisei Industry Co., Ltd. (wire diameter, 0.26 mm; length, 200 mm) was provided.

The elongated piezoelectric body was wound on the periphery of the inner conductor at a helix angle of about 45° in a left-handed manner while formation of gaps was avoided as much as possible. By this, a piezoelectric layer covering the periphery of the inner conductor was formed to obtain a two-layered piezoelectric base material. The piezoelectric layer covered the entire periphery of the inner conductor. Thus, the periphery of the inner conductor was not exposed. The piezoelectric layer was not fixed to the inner conductor with an adhesive or the like.

The term "left-handed manner" means that, as seen from one end in the axial direction of the inner conductor (tinsel wire), the elongated piezoelectric body is wound in a left-handed manner from the near side to the far side of the inner conductor. The term "helix angle" means the angle of the longitudinal direction of the elongated piezoelectric body with respect to the axial direction of the inner conductor.

Using the elongated piezoelectric body, the elastic modulus Y of the elongated piezoelectric body was measured by the following method. The elastic modulus Y of the elongated piezoelectric body was determined by a microhardness measurement in accordance with JIS Z 2255. As a result of the measurement, the elastic modulus Y of the elongated piezoelectric body was found to be 3.9 GPa.

(Measurement of Elastic Modulus Y of Elongated Piezoelectric Body)

The elastic modulus Y of the elongated piezoelectric body was measured as the indentation elastic modulus of the elongated piezoelectric body using a dynamic ultra-microhardness meter by a method in accordance with JIS Z 2255.

More specifically, the elastic modulus Y of the elongated piezoelectric body was determined as follows. From the piezoelectric layer of a measurement sample (two-layered piezoelectric base material), the elongated piezoelectric body was unwound to obtain a measurement sample. In a case where the elongated piezoelectric body was curled, the curled elongated piezoelectric body was cut into a piece of about several millimeters, to obtain a measurement sample. The measurement sample was fixed on a base plate, and evaluation was carried out by performing the measurement by pushing an indenter from a flat portion of the measurement sample.

The apparatus used in the measurement was a dynamic ultra-microhardness meter "DUH-211R" (manufactured by Shimadzu Corporation). As the indenter, a diamond triangular pyramid indenter (ridge angle, 115°) was used. The measurement was carried out under soft sample measurement conditions at a temperature of 23 ± 2°C and a humidity of 50 ± 5°C.

The elastic modulus Y of the elongated piezoelectric body is a value evaluated from the degree of elastic recovery in the early phase of the unloading process, and is calculated using the formulae [Formula 1] to [Formula 4] in Example 1. The elastic modulus Y used herein is a value calculated without taking the Poisson ratio of the measurement sample into account, that is, a value calculated by taking the Poisson ratio as 0.

<Preparation of Three-Layered Piezoelectric Base Material>

As an outer conductor, a flattened copper foil ribbon having a rectangular cross-section was provided. The flattened copper foil ribbon had a width of 0.3 mm. The flattened copper foil ribbon had a thickness of 30 $\mu$m.

The flattened copper foil ribbon was wound, in a right-handed manner, on the periphery of the piezoelectric layer used for the measurement of the elastic modulus Y of the elongated piezoelectric body, such that no gaps were formed to cause exposure of the piezoelectric layer. The outer conductor covered the entire periphery of the piezoelectric layer. Thus, the periphery of the piezoelectric layer was not exposed. The outer conductor was not fixed to the piezoelectric layer by an adhesive or the like.

A three-layered piezoelectric base material was thus prepared.

Subsequently, as a process before attachment of terminals, terminal-attachment preparation was carried out. In the terminal-attachment preparation, the piezoelectric layer and the outer conductor were peeled off from both end portions of the three-layered piezoelectric base material, to expose the tinsel wire. More specifically, in the terminal-attachment preparation, portions with a length required for the terminals were unwound, and the outer conductor at both end portions of the three-layered piezoelectric base material was peed off from the piezoelectric layer. Subsequently, portions with a length required for the terminals were unwound, the piezoelectric layer was removed for a length of 5 mm for taking out the inner conductor. By this, the tinsel wire was exposed.

In Example 5, the inner conductor, the piezoelectric layer, and the outer conductor are not mechanically integrated together with an adhesive or the like. Therefore, the inner conductor and the outer conductor were not broken in the process of removal of the piezoelectric layer. The time required for the terminal-attachment preparation was not more than 2 minutes. The term "time required for the terminal-attachment preparation" means the length of time from the time point when the operation of exposing the tinsel wire was started to the time point when the tinsel wire was exposed.

<Measurement of Piezoelectric Sensitivity of Three-Layered Piezoelectric Base Material (Electrometer)>

Using an electrometer, the piezoelectric sensitivity (pC/N·mm) of a three-layered piezoelectric base material was measured by the following method.

As a result, the piezoelectric sensitivity of the three-layered piezoelectric base material was found to be 3.3 pC/N·mm.

- Method of Measuring Piezoelectric Sensitivity (pC/N·mm) of Three-Layered Piezoelectric Base Material (Electrometer) -

The three-layered piezoelectric base material was chucked in a tensile tester ("Tensilon RTG 1250", manufactured by A&D Company, Ltd.) with a chuck distance of 150 mm. More specifically, a crimp terminal (an electric and mechanical connecting portion) at one end side of the three-layered piezoelectric base material was chucked with one chuck member, and a crimp terminal (an electric and mechanical connecting portion) at the other end side of the three-layered piezoelectric base material was chucked with the other chuck member. Further, an electrode for measurement of the amount of charge in an electrometer (programmable electric meter "617", manufactured by Keithley Instruments, Inc.) was connected to a crimp terminal of the three-layered piezoelectric base material, and a ground electrode of the electrometer (programmable electric meter "617", manufactured by Keithley Instruments, Inc.) was connected to the outer conductor (flattened copper foil ribbon) of the three-layered piezoelectric base material.

Subsequently, using a tensile tester, tensions were periodically and repeatedly applied in the form of triangular waves to the three-layered piezoelectric base material within a stress range of from 1 N to 2 N at a constant moving speed of 5 mm/minute while measuring the amount of charge generated in the inner conductor side of the three-layered piezoelectric base material using an electrometer (programmable electric meter "617", manufactured by Keithley Instruments, Inc.).

The amount of generated charge per unit tensile force was calculated from the slope of a correlation line in a scatter diagram obtained by plotting the measured amount of generated charge Q [C] on the Y-axis, and plotting the tensile force F [N] of the three-layered piezoelectric base material on the X-axis, and the calculated value was divided by the distance between the crimp terminals, to determine the piezoelectric sensitivity (pC/N·mm).

<Comparative Example 5>

The same refined silk and inner conductor as in Example 5 were provided.

In Comparative Example 5, instead of winding the elongated piezoelectric body in Example 5 around the periphery of the inner conductor, four refined silk yarns were helically wound on the periphery of the inner conductor such that the yarns were aligned side by side, and such that no gaps were formed to cause exposure of the inner conductor. Further, four refined silk yarns were similarly wound such that the yarns were aligned side by side.

The helix angle of the refined silk was set to about 45°, and the refined silk was wound in a left-handed manner. By this, a refined-silk layer covering the periphery of the inner conductor was formed. The refined-silk layer covered the entire periphery of the inner conductor. Thus, the periphery of the inner conductor was not exposed.

The term "helix angle" of the refined silk means the angle of the longitudinal direction of the refined silk with respect to the long-axis direction of the inner conductor.

Subsequently, as an adhesive, "ARON ALPHA 901H3" (a cyanoacrylate adhesive), manufactured by Toagosei Co., Ltd., was provided.

The adhesive was added dropwise onto the periphery of the refined-silk layer, to impregnate the refined-silk layer with the adhesive. Thereafter, heat treatment was carried out at 120°C for 6 hours. By this, the refined-silk layer was fixed and joined to the inner conductor, to achieve their mechanical integration. By this, a piezoelectric layer covering the periphery of the inner conductor was formed to obtain a two-layered piezoelectric base material. The piezoelectric layer was found to be fixed to the inner conductor by the adhesive.

Subsequently, as an outer conductor, a flattened copper foil ribbon having a rectangular cross-section was provided. The flattened copper foil ribbon had a width of 0.3 mm. The flattened copper foil ribbon had a thickness of 30 μm.

The flattened copper foil ribbon was wound, in a right-handed manner, on the periphery of the piezoelectric layer used for the measurement of the elastic modulus Y of the elongated piezoelectric body, such that no gaps were formed to cause exposure of the piezoelectric layer. The outer conductor covered the entire periphery of the piezoelectric layer. Thus, the periphery of the piezoelectric layer was not exposed. The outer conductor was not fixed to the piezoelectric layer by an adhesive or the like.

A three-layered piezoelectric base material was thus prepared.

Subsequently, as a process before attachment of terminals, terminal-attachment preparation was carried out. In the terminal-attachment preparation, the piezoelectric layer and the outer conductor were peeled off from both end portions of the three-layered piezoelectric base material, to expose the tinsel wire. More specifically, in the terminal-attachment preparation, portions with a length required for the terminals were unwound, and the outer conductor at both end portions of the three-layered piezoelectric base material was peed off from the piezoelectric layer. Subsequently, portions with a length required for the terminals were unwound, and the piezoelectric layer was removed for a length of 5 mm for taking out the inner conductor. By this, the tinsel wire was exposed.

In Comparative Example 5, the inner conductor and the piezoelectric layer were mechanically integrated together by the adhesive. Therefore, the length of time required for the terminal-attachment preparation was not less than 5 times longer than in Example 5. The term "time required for the terminal-attachment preparation" means the length of time required for the process from the time point when the operation of exposing the tinsel wire was started to the time point when the tinsel wire was exposed.

In the same manner as in Example 5, the piezoelectric sensitivity (pC/N·mm) of the three-layered piezoelectric base material was measured. As a result, the piezoelectric sensitivity of the three-layered piezoelectric base material was found to be 2.8 pC/N·mm.

The three-layered piezoelectric base material of Comparative Example 5 includes an elongated inner conductor, and a piezoelectric layer covering the periphery of the inner conductor. The piezoelectric layer was formed by winding an elongated piezoelectric body around the periphery of the inner conductor. The elongated piezoelectric body includes four piezoelectric yarns, and an adhesive body that maintains a state in which the four piezoelectric yarns are wound around the periphery of the inner conductor. However, the piezoelectric layer was fixed to the inner conductor by the adhesive.

Therefore, the piezoelectric sensitivity of the three-layered piezoelectric base material was 2.8 pC/N·mm. Further, the length of time required for the terminal-attachment preparation was not less than 5 times longer than in Example 5. As a result, the three-layered piezoelectric base material of Comparative Example 5 was found to be incapable of enabling efficient terminal-attachment preparation, and not to have excellent piezoelectric sensitivity.

The three-layered piezoelectric base material of Example 5 includes an elongated inner conductor, and a piezoelectric layer covering the periphery of the inner conductor. The piezoelectric layer was formed by winding an elongated piezoelectric body around the inner conductor, and was not fixed to the inner conductor. The elongated piezoelectric body includes four piezoelectric yarns, and an adhesive body bundling the four piezoelectric yarns.

Therefore, the piezoelectric sensitivity of the three-layered piezoelectric base material was higher than in Comparative Example 5, and was 3.3 pC/N·mm. Further, the length of time required for the terminal attachment was shorter than in Comparative Example 5, and was not more than 2 minutes. As a result, the three-layered piezoelectric base material of Example 5 was found to be capable of enabling efficient terminal-attachment preparation, and to have excellent piezoelectric sensitivity.

The disclosure of Japanese Patent Application No. 2021-061998, filed on March 31, 2021, and the disclosure of Japanese Patent Application No. 2021-061999, filed on March 31, 2021, are incorporated herein by reference in their entirety.

All documents, patent applications, and technical standards cited in the present description are incorporated herein by reference to the same extent as in cases where the individual documents, patent applications, and technical standards are specifically and individually described to be incorporated by reference.

**Claims**

1. A piezoelectric base material, comprising:

   an elongated inner conductor; and
   a piezoelectric layer covering a periphery of the inner conductor, the piezoelectric layer comprising:

   a piezoelectric yarn wound around the inner conductor; and
   an adhering section that maintains a state in which the piezoelectric yarn is wound around the inner conductor,

   the piezoelectric yarn comprising an optically active polypeptide fiber that is a fiber comprising an optically active polypeptide, and
   the piezoelectric layer having an elastic modulus Y of from 1.0 GPa to 8.0 GPa as measured by a microhardness measurement in accordance with JIS Z 2255.

**2.** The piezoelectric base material according to claim 1, wherein a longitudinal direction of the piezoelectric yarn is substantially parallel to a main orientation direction of the optically active polypeptide.

**3.** The piezoelectric base material according to claim 1 or 2, wherein the optically active polypeptide fiber has a degree of orientation F of from 0.50 to less than 1.00 as determined by the following Formula (a) based on X-ray diffractometry:

$$\text{Formula (a): degree of orientation } F = (180° - \alpha)/180°$$

wherein, in Formula (a), $\alpha$ is a half-width (°) of a peak derived from the orientation.

**4.** The piezoelectric base material according to any one of claims 1 to 3, wherein the piezoelectric yarn is helically wound in a single direction.

**5.** The piezoelectric base material according to claim 4, wherein a helix angle of from 20° to 70° is formed between an axial direction of the inner conductor and a longitudinal direction of the piezoelectric yarn.

**6.** The piezoelectric base material according to any one of claims 1 to 5, wherein the adhering section comprises at least one selected from epoxy adhesives, urethane adhesives, vinyl acetate resin emulsion-type adhesives, ethylene vinyl acetate emulsion-type adhesives, acrylic resin emulsion-type adhesives, styrene-butadiene rubber latex-type adhesives, silicone resin adhesives, $\alpha$-olefin adhesives, vinyl chloride resin solvent-type adhesives, rubber adhesives, elastic adhesives, chloroprene rubber solvent-type adhesives, nitrile rubber solvent-type adhesives, or cyanoacrylate adhesives.

**7.** The piezoelectric base material according to any one of claims 1 to 6, further comprising an outer conductor at a peripheral side of the piezoelectric layer, wherein the inner conductor is not electrically connected to the outer conductor.

**8.** The piezoelectric base material according to any one of claims 1 to 7, wherein the optically active polypeptide has a $\beta$-sheet structure.

**9.** The piezoelectric base material according to any one of claims 1 to 8, wherein the optically active polypeptide comprises at least one of fibroin or spider silk protein.

**10.** The piezoelectric base material according to any one of claims 1 to 9, wherein the optically active polypeptide fiber comprises at least one of silk or spider silk.

**11.** The piezoelectric base material according to claim 10, wherein the silk is refined silk.

**12.** The piezoelectric base material according to any one of claims 1 to 11, wherein:

each piezoelectric yarn comprises a plurality of optically active polypeptide fibers, and
a number of twists of the piezoelectric yarn is not more than 500 T/m.

**13.** The piezoelectric base material according to any one of claims 1 to 12, further comprising an electrical insulator at an outermost periphery.

**14.** A sensor, comprising the piezoelectric base material according to any one of claims 1 to 13.

**15.** An actuator, comprising the piezoelectric base material according to any one of claims 1 to 13.

**16.** A biological information acquisition device, comprising the piezoelectric base material according to any one of claims 1 to 13.

**17.** A piezoelectric base material, comprising:

an elongated inner conductor; and
a piezoelectric layer covering a periphery of the inner conductor,

the piezoelectric layer being formed by winding an elongated piezoelectric body around the inner conductor, and not being fixed to the inner conductor,

the elongated piezoelectric body comprising a plurality of piezoelectric yarns and a bundling body for bundling the plurality of piezoelectric yarns, and

at least one of the plurality of piezoelectric yarns comprising an optically active polypeptide fiber that is a fiber comprising an optically active polypeptide.

18. The piezoelectric base material according to claim 17, wherein a longitudinal direction of the elongated piezoelectric body is substantially parallel to a main orientation direction of the optically active polypeptide.

19. The piezoelectric base material according to claim 17 or claim 18, wherein the optically active polypeptide fiber has a degree of orientation F of from 0.50 to less than 1.00 as determined by the following Formula (a) based on X-ray diffractometry:

$$\text{Formula (a): degree of orientation } F = (180° - \alpha)/180°$$

wherein, in Formula (a), $\alpha$ is a half-width (°) of a peak derived from the orientation.

20. The piezoelectric base material according to any one of claims 17 to claim 19, wherein the elongated piezoelectric body is helically wound in a single direction.

21. The piezoelectric base material according to claim 20, wherein a helix angle of from 20° to 70° is formed between an axial direction of the inner conductor and a longitudinal direction of the elongated piezoelectric body.

22. The piezoelectric base material according to any one of claims 17 to 21, wherein the bundling body bundles the plurality of piezoelectric yarns in a state in which the plurality of piezoelectric yarns are aligned parallel to each other along a direction perpendicular to a longitudinal direction of the plurality of piezoelectric yarns, and in which piezoelectric yarns adjacent to each other among the plurality of piezoelectric yarns are in contact with each other.

23. The piezoelectric base material according to any one of claims 17 to 22, wherein the bundling body comprises at least one selected from epoxy adhesives, urethane adhesives, vinyl acetate resin emulsion-type adhesives, ethylene vinyl acetate emulsion-type adhesives, acrylic resin emulsion-type adhesives, styrene-butadiene rubber latex-type adhesives, silicone resin adhesives, $\alpha$-olefin adhesives, vinyl chloride resin solvent-type adhesives, rubber adhesives, elastic adhesives, chloroprene rubber solvent-type adhesives, nitrile rubber solvent-type adhesives, or cyanoacrylate adhesives.

24. The piezoelectric base material according to any one of claims 17 to 23, wherein:

the elongated piezoelectric body has a thickness of from 0.001 mm to 0.4 mm,
the elongated piezoelectric body has a width of from 0.1 mm to 30 mm, and
a ratio of the width of the elongated piezoelectric body to the thickness of the elongated piezoelectric body is not less than 2.

25. The piezoelectric base material according to any one of claims 17 to 24, wherein the elongated piezoelectric body has an elastic modulus Y of from 1 GPa to 10 GPa as measured by a microhardness measurement in accordance with JIS Z 2255.

26. The piezoelectric base material according to any one of claims 17 to 25, further comprising an outer conductor at a peripheral side of the piezoelectric layer, wherein the inner conductor is not electrically connected to the outer conductor.

27. The piezoelectric base material according to any one of claims 17 to 26, wherein the optically active polypeptide has a $\beta$-sheet structure.

28. The piezoelectric base material according to any one of claims 17 to 27, wherein the optically active polypeptide comprises at least one of fibroin or spider silk protein.

29. The piezoelectric base material according to any one of claims 17 to 28, wherein the fiber comprising an optically active polypeptide comprises at least one of silk or spider silk.

30. The piezoelectric base material according to claim 29, wherein the silk is refined silk.

31. The piezoelectric base material according to any one of claims 17 to 30, wherein:

each of the plurality of piezoelectric yarns comprises a plurality of the optically active polypeptide fibers, and a number of twists of each of the plurality of piezoelectric yarns is not more than 500 T/m.

32. The piezoelectric base material according to any one of claims 17 to 31, further comprising an electrical insulator at an outermost periphery.

33. A sensor, comprising the piezoelectric base material according to any one of claims 17 to 32.

34. An actuator, comprising the piezoelectric base material according to any one of claims 17 to 32.

35. A biological information acquisition device, comprising the piezoelectric base material according to any one of claims 17 to 32.

## FIG.1A

## FIG.1B

# FIG.2

20A

14A,140A

12A

G1

22A

# FIG.3A

10B

β1

ID→

14B,140B   12B

12B

G1

E1

ID→

## FIG.3B

140B

141 142 141 142 141 142 141

IC IC

## FIG.3C

140B

141 142 141 142 141 142 141

FIG.3D

FIG.4

## INTERNATIONAL SEARCH REPORT

| International application No. |
| --- |
| **PCT/JP2022/016136** |

**A.    CLASSIFICATION OF SUBJECT MATTER**

*G01L 1/16*(2006.01)i; *H01L 41/087*(2006.01)i; *H01L 41/09*(2006.01)i; *H01L 41/113*(2006.01)i; *H01L 41/193*(2006.01)i
FI:    H01L41/087; H01L41/09; H01L41/113; H01L41/193; G01L1/16 A

According to International Patent Classification (IPC) or to both national classification and IPC

**B.    FIELDS SEARCHED**

Minimum documentation searched (classification system followed by classification symbols)

G01L1/16; H01L41/087; H01L41/09; H01L41/113; H01L41/193

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
| --- | --- | --- |
| X | JP 2020-36027 A (MITSUI CHEMICALS INC.) 05 March 2020 (2020-03-05)<br>    paragraphs [0005], [0014], [0030]-[0032], [0048], [0073], [0074], [0106], [0109], [0131],<br>    [0166], [0172], [0185], [0191], [0192], fig. 1A, table 2, examples 3, 4 | 17-22, 24, 26, 32-35 |
| Y | | 23, 25, 27-31 |
| Y | WO 2018/092886 A1 (MITSUI CHEMICALS INC.) 24 May 2018 (2018-05-24)<br>    paragraphs [0003], [0004], [0018], [0031]-[0034], [0044], [0055], [0059], [0063], [0066],<br>    [0075], [0077], [0097], [0126]-[0128], [0133], fig. 1, 2, table 2 | 1-16, 23, 27-31 |
| A | | 17-22, 24-26, 32-35 |
| Y | WO 2017/213108 A1 (MITSUI CHEMICALS INC.) 14 December 2017 (2017-12-14)<br>    paragraphs [0004], [0043]-[0045], [0080], [0119]-[0121], fig. 3 | 1-16, 25 |
| A | | 17-24, 26-35 |
| Y | JP 2014-186320 A (KYOCERA CORP.) 02 October 2014 (2014-10-02)<br>    paragraphs [0059], [0068] | 1-16, 25 |
| A | | 17-24, 26-35 |

☑ Further documents are listed in the continuation of Box C.        ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **17 June 2022** | **28 June 2022** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT

| International application No. |
|---|
| **PCT/JP2022/016136** |

### C.    DOCUMENTS CONSIDERED TO BE RELEVANT

| Category* | Citation of document, with indication, where appropriate, of the relevant passages | Relevant to claim No. |
|---|---|---|
| A | WO 2017/212836 A1 (MURATA MANUFACTURING CO., LTD.) 14 December 2017 (2017-12-14)<br>        entire text, all drawings | 1-35 |

Form PCT/ISA/210 (second sheet) (January 2015)

**INTERNATIONAL SEARCH REPORT**
Information on patent family members

International application No.

**PCT/JP2022/016136**

| Patent document cited in search report | | | Publication date (day/month/year) | Patent family member(s) | | | Publication date (day/month/year) |
|---|---|---|---|---|---|---|---|
| JP | 2020-36027 | A | 05 March 2020 | US | 2019/0003905 | A1 | |
| | | | | paragraphs [0015], [0122]-[0126], [0187]-[0196], [0224]-[0230], [0304]-[0311], [0379]-[0381], [0402]-[0404], [0471], [0472], [0579]-[0588], [0613]-[0617], [0649]-[0655], [0669]-[0671], fig. 1A, table 2, examples 3, 4 | | | |
| | | | | WO | 2017/111108 | A1 | |
| | | | | EP | 3376549 | A1 | |
| | | | | KR | 10-2018-0082499 | A | |
| | | | | CN | 108701753 | A | |
| WO | 2018/092886 | A1 | 24 May 2018 | US | 2020/0058844 | A1 | |
| | | | | paragraphs [0009]-[0014], [0076]-[0079], [0104]-[0117], [0142], [0143], [0185], [0186], [0198], [0209]-[0213], [0218], [0219], [0241]-[0243], [0247]-[0252], [0314]-[0318], [0381]-[0395], [0408]-[0410], fig. 1A-2, table 2 | | | |
| | | | | EP | 3534419 | A1 | |
| | | | | CN | 109964326 | A | |
| WO | 2017/213108 | A1 | 14 December 2017 | US | 2019/0267538 | A1 | |
| | | | | paragraphs [0012], [0172]-[0179], [0276]-[0283], [0407]-[0417], fig. 3 | | | |
| | | | | EP | 3471159 | A1 | |
| | | | | CN | 109314179 | A | |
| JP | 2014-186320 | A | 02 October 2014 | (Family: none) | | | |
| WO | 2017/212836 | A1 | 14 December 2017 | JP | 2017-220658 | A | |
| | | | | US | 2019/0078239 | A1 | |
| | | | | entire text, all drawings | | | |
| | | | | JP | 2018-75348 | A | |
| | | | | JP | 2018-76629 | A | |
| | | | | JP | 2018-90950 | A | |
| | | | | JP | 2019-131948 | A | |
| | | | | US | 2021/0269948 | A1 | |
| | | | | WO | 2017/212523 | A1 | |
| | | | | WO | 2017/212666 | A1 | |
| | | | | WO | 2018/084054 | A1 | |
| | | | | EP | 3467169 | A1 | |
| | | | | CN | 109312500 | A | |

Form PCT/ISA/210 (patent family annex) (January 2015)

**EP 4 300 063 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2018092886 A
- JP 2021061998 A
- JP 2021061999 A